(19) Europäisches Patentamt
European Patent Office
Office européen des brevets

(11) EP 1 213 766 B1

(12) **EUROPÄISCHE PATENTSCHRIFT**

(45) Veröffentlichungstag und Bekanntmachung des Hinweises auf die Patenterteilung:
**19.01.2011 Patentblatt 2011/03**

(51) Int Cl.:
***H01L 29/06*** *(2006.01)* ***H01L 29/78*** *(2006.01)*
***H01L 21/336*** *(2006.01)*

(21) Anmeldenummer: **01127071.7**

(22) Anmeldetag: **14.11.2001**

(54) **Halbleiterbauelement mit erhöhter Durchbruchspannung sowie dazugehöriges Herstellungsverfahren**

High breakdown voltage semiconductor device and process for fabricating the same

Dispositif semi-conducteur à tension de claquage élevée et procédé pour sa fabrication

(84) Benannte Vertragsstaaten:
**DE**

(30) Priorität: **08.12.2000 DE 10061310**

(43) Veröffentlichungstag der Anmeldung:
**12.06.2002 Patentblatt 2002/24**

(73) Patentinhaber: **Infineon Technologies AG**
**85579 Neubiberg (DE)**

(72) Erfinder:
- **Weber, Hans, Dr.**
  **83404 Ainring (DE)**
- **Ahlers, Dirk, Dr.**
  **80796 München (DE)**
- **Stengl, Jens-Peer**
  **82284 Grafrath (DE)**
- **Deboy, Gerald, Dr.**
  **81543 München (DE)**
- **Rüb, Michael, Dr.**
  **9583 Faak/See (AT)**
- **Marion, Miguel Cuadron**
  **81543 München (DE)**
- **Willmeroth, Armin**
  **86163 Augsburg (DE)**

(74) Vertreter: **Kindermann, Peter**
**Kindermann Patentanwälte**
**Postfach 100234**
**85593 Baldham (DE)**

(56) Entgegenhaltungen:
**WO-A-00/14807** **DE-A1- 10 106 006**
**DE-A1- 19 954 352** **DE-A1- 19 958 234**

- **STENGL R ET AL: "VARIATION OF LATERAL DOPING - A NEW CONCEPT TO AVOID HIGH VOLTAGE BREAKDOWN OF PLANAR JUNCTIONS" INTERNATIONAL ELECTRON DEVICES MEETING. WASHINGTON, DEC. 1 - 4, 1985, WASHINGTON, IEEE, US, 1. Dezember 1985 (1985-12-01), Seiten 154-157, XP002013050**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die vorliegende Erfindung bezieht sich auf ein Halbleiterbauelement mit erhöhter Durchbruchspannung sowie ein dazugehöriges Herstellungsverfahren und insbesondere auf ein Kompensationsbauelement mit verbessertem Randabschluss.

Halbleiterbauelemente und insbesondere Leistungsbauelemente benötigen insbesondere in einem Randbereich Strukturen, die in Grenzbelastungen (wie z.B. avalanche-Belastung) des Hauptbauelements vor Überlastung bzw. Durchbruch geschützt werden. Insbesondere in Randbereichen eines Halbleiterbauelements, an denen auf Grund des leitenden Chiprandes ein Substratpotential (Drainpotential) auch an der Oberfläche des Chips anliegt, treten gekrümmte Potentialfeldlinien auf, die zu einem erhöhten elektrischen Feld und zu einem frühen Durchbruch führen. Bei herkömmlichen Leistungsbauelementen, die nicht auf einem Kompensationsprinzip beruhen, ist eine Realisierung von durchbruchsicheren Randstrukturen nur mit großem technologischen Aufwand möglich.

Zu Halbleiterbauelementen, die auf dem Kompensationsprinzip basieren, gibt es über einen langen Zeitraum verstreut, verschiedene theoretische Untersuchungen (vergleiche US 4,754,310 und US 5,216,275), in denen jedoch speziell Verbesserungen des Einschaltwiderstandes $R_{DS(on)}$ und nicht die Stabilität bei Strombelastung, wie insbesondere Robustheit hinsichtlich "avalanche" und Kurzschluss im Hochstromfall bei hoher Source-Drain-Spannung, angestrebt werden. Insbesondere eine Übertragung dieses Kompensationsprinzips auf nicht aktive Randstrukturen, wie sie beispielsweise in einem Randbereich oder Zwischenbereich benötigt werden, sind bisher nicht bekannt.

Aus der Druckschrift US 4,750,028 ist ferner ein Halbleiterbauelement mit einer Randstruktur bekannt, die zur Verbesserung einer Durchbruchspannung mehrere schwebende Zonen innerhalb einer Raumladungszone einer aktiven Struktur aufweist. Die schwebenden Zonen werden hierbei jedoch derart ausgebildet, das sie nur teilweise von Ladungsträgern ausgeräumt werden.

Das Kompensationsprinzip von Kompensationsbauelementen beruht auf einer gegenseitigen Kompensation der Ladung von n- und p-dotierten Gebieten in der Driftregion des Transistors. Die Gebiete sind dabei räumlich so angeordnet, dass das Linienintegral über die Dotierung entlang einer vertikal zum pn-Übergang verlaufenden Linie jeweils unterhalb der materialspezifischen Durchbruchsladung bleibt (Silizium: ca. $2x10^{12}$ $cm^{-2}$). Beispielsweise können in einem Vertikaltransistor, wie er in der Leistungselektronik üblich ist, paarweise p- und n-Säulen oder Platten etc. angeordnet sein.

Durch die weitgehende Kompensation der p- und n-Dotierungen lässt sich bei Kompensationsbauelementen die Dotierung des stromführenden Bereichs (für n-Kanal-Transistoren der n-Bereich, für p-Kanal-Transistoren der p-Bereich) deutlich erhöhen, woraus trotz des Verlusts an stromführender Fläche ein deutlicher Gewinn an Einschaltwiderstand $R_{DS(on)}$ resultiert. Die Sperrfähigkeit des Transistors hängt dabei im Wesentlichen von der Differenz der beiden Dotierungen ab. Da aus Gründen der Reduktion des Einschaltwiderstandes eine um mindestens eine Größenordnung höhere Dotierung des stromführenden Gebiets erwünscht ist, erfordert die Beherrschung der Sperrspannung eine kontrollierte Einstellung des Kompensationsgrades, der für Werte im Bereich $\leq \pm 10\%$ definierbar ist. Bei einem höheren Gewinn an Einschaltwiderstand wird der genannte Bereich noch kleiner. Der Kompensationsgrad ist dabei definierbar durch

$$(p\text{-Dotierung} - n\text{-Dotierung})/n\text{-Dotierung}$$

oder durch

Ladungsdifferenz/Ladung eines Dotierungsgebiets.

Aus der gattungsbildenden Druckschrift WO 00/14807 A ist ein Halbleiterbauelement sowie ein zugehöriges Herstellungsverfahren bekannt, wobei eine aktive Struktur einen sperrenden pn-Übergang in einem Halbleitersubstrat aufweist, mit einer ersten Zone eines ersten Leitungstyps, die mit einer ersten Elektrode verbunden ist und an eine den sperrenden pn-Übergang bildende Zone eines zweiten, zum ersten Leitungstyp entgegengesetzten Leitungstyps angrenzt, die ebenfalls mit der ersten Elektrode verbunden ist, und mit einer zweiten Zone des ersten Leitungstyps, die mit einer zweiten Elektrode verbunden ist, wobei im Bereich zwischen der ersten Zone und der zweiten Zone erste und zweite Kompensationsgebiete des ersten und zweiten Leitungstyps ineinander verschachtelt sind. Dieses Halbleiterbauelement weist ferner eine Randstruktur mit Übergangsstruktur auf, die sich von der restlichen Randstruktur unterscheidet, wobei eine Vielzahl von ersten Rand-Kompensationsgebieten des ersten Leitungstyps und eine Vielzahl von schwebenden zweiten Rand-Kompensationsgebieten des zweiten Leitungstyps ausgebildet sind, die eine Vielzahl von Rand-Kompensationszonen aufweisen und mit den ersten Rand-Kompensationsgebieten derart verschachtelt sind, dass die zweiten Rand-Kompensationsgebiete vor Erreichen einer Durchbruchspannung vollständig von Ladungsträgern ausgeräumt werden.

Aus der Druckschrift DE 199 54 352 A1 ist ein weiteres herkömmliches Halbleiterbauelement mit einer aktiven Struktur und einer Randstruktur bekannt, wobei zur Realisierung einer hohen Spannungsfestigkeit in der Randstruktur eine epitaktisch aufgewachsene und sehr schwach dotierte Driftzone ausgebildet wird.

Ferner ist aus der Druckschrift Stengl et al.: "Variation of Lateral Doping - A New Concept to Avoid High Voltage Breakdown of Planar Junctions" International Electron Devices Meeting, Washington, Dec. 1-4, 1985, Washington, IEEE, US, 1. December 1985, Seiten 154-157, XP002013050 ein Konzept zur Verbesserung der Durchbruchfestigkeit bei planaren Halbleiterbauelementen bekannt, wobei ein abgestufter Randabschluss mit flachem lateralem Dotiergradienten vorgeschlagen wird.

Um nachhaltige Schädigungen bzw. eine Zerstörung von Halbleiterbauelementen zu verhindern, müssen daher insbesondere gefährdete Bereiche wie Randbereiche bei Grenzbelastungen eines Hauptbauelements vor Überlastung geschützt werden und eine höhere Durchbruchspannung aufweisen.

Der Erfindung liegt daher die Aufgabe zu Grunde, ein Halbleiterbauelement mit erhöhter Durchbruchspannung sowie ein dazugehöriges Herstellungsverfahren zu schaffen, welches einen verbesserten Randabschluss aufweist.

Erfindungsgemäß wird diese Aufgabe hinsichtlich des Halbleiterbauelements durch die Merkmale des Patentanspruchs 1 und hinsichtlich des Verfahrens durch die Maßnahmen des Patentanspruchs 15 gelöst.

Da die Kompensationsgrade der Rand-Kompensationszonen (4) der Übergangsstruktur einerseits und der korrespondierenden Kompensationszonen (4') der aktiven Struktur andererseits invertiert und nicht gleich sind, kann eine Randstruktur optimal an eine aktive Struktur angepasst werden, wodurch sich die elektrischen Eigenschaften des Halbleiterbauelements verbessern lassen.

Vorzugsweise wird die Randstruktur in einem Randbereich des Halbleiterbauelements realisiert, wodurch die am Chiprand auftretenden Kurzschlüsse mit den einhergehenden Potentialfeldverbiegungen und erhöhten elektrischen Feldern verringert werden. Die Randstruktur kann jedoch auch für einen Zwischenbereich zwischen einem Hauptelement und einem Nebenelement des Halbleiterbauelements verwendet werden, wodurch beispielsweise in einem Kompensationselement verwendete Sensorelemente zuverlässig und kostengünstig in das Hauptelement eingebettet werden können.

Vorzugsweise besitzt die Randstruktur eine Zellenstruktur, die im Wesentlichen einer Zellenstruktur der aktiven Struktur des Halbleiterbauelements entspricht, wodurch sich die Kosten weiter verringern lassen und eine nahtlose Anbindung der Randstruktur an die aktive Struktur des Halbleiterbauelements ermöglicht wird.

Vorzugsweise besteht die Zellenstruktur der Randstruktur im Wesentlichen aus einem Vieleck wie z.B. einer hexagonalen Struktur.

Vorzugsweise sind die Vielzahl von Rand-Kompensationszonen ringförmig ausgebildet und beispielsweise an die Zellenstruktur der Randstruktur angepasst. Auf diese Weise erhöht man auf besonders vorteilhafte Weise die Durchbruchspannung in der Randstruktur.

Ferner können die Vielzahl von Rand-Kompensationszonen in Abhängigkeit von den jeweiligen Erfordernissen unterschiedliche Kompensationsgrade aufweisen, wodurch sich eine selektive Anpassung der Durchbruchsicherheit an lokale Gegebenheiten realisieren lässt.

Erfindungsgemäß kann unter Verwendung von Zellnachbar-Wechselwirkungen bzw. einem vorliegenden Durchgriff eine Randstruktur derart optimiert werden, dass sich auch in sich unmittelbar berührenden Zellen der aktiven Struktur und der Randstruktur verbesserte Durchbruchspannungen ergeben.

Vorzugsweise kann eine Variation der Größe der Vielzahl von Kompensationszonen in einer x-, y- und z-Richtung gleichmäßig und/oder verschieden durchgeführt werden. Auf diese Weise lassen sich nicht nur Inhomogenitäten an einer Oberfläche des Wafers bzw. Chips in Abhängigkeit von den jeweiligen Erfordernissen optimal anpassen, sondern derartige Anpassungen auch in vertikaler Richtung beispielsweise auch unterhalb der aktiven Struktur realisieren. Eine Erhöhung der Durchbruchspannung ist somit im gesamten dreidimensionalen Bereich des Halbleiterbauelements möglich.

Vorzugsweise wird die Vielzahl von Rand-Kompensationszonen in x-, y- und z-Richtung mit und/oder ohne ein Raster ausgebildet, wodurch sich eine weitergehende flexible Anpassung an lokale Gegebenheiten zur Erhöhung der Durchbruchspannung in der Randstruktur realisieren lassen.

Vorzugsweise ist eine Gesamtdotierung im Bereich der Randstruktur geringer als in der aktiven Struktur, wodurch sich die erhöhte Durchbruchspannung besonders kostengünstig realisieren lässt.

Ferner kann eine Grabenstruktur einen Teil der Dotierung in der Randstruktur entfernen, wodurch sich wiederum eine Verbesserung der Durchbruchspannung in der Randstruktur ergibt. In den weiteren Ansprüchen sind weitere vorteilhafte Ausgestaltungen der Erfindung gekennzeichnet.

Die Erfindung wird nachstehend anhand eines Ausführungsbeispiels unter Bezugnahme auf die Zeichnung näher beschrieben.

Es zeigen:

Figur 1 eine vereinfachte Schnittansicht einer nicht bean- spruchten Randstruktur und einer aktiven Struktur in einem Kompensationsbauelement;

Figur 2 eine vereinfachte Schnittansicht zur Veranschauli- chung von möglichen Herstellungsschritten der Rand- struktur gemäß Figur 1, die auf das Ausführungsbei- spiel der Erfindung angewandt werden können;

Figuren 3A bis 3C eine vereinfachte Schnittansicht, eine zugehörige Nettodotierung, und eine zugehörige elektrische Feldstärke einer nicht beanspruchten Elementarzelle der Randstruktur zur Veranschauli- chung einer homogenen Feldstärke;

Figuren 4A bis 4C eine vereinfachte Schnittansicht, eine zugehörige Nettodotierung und eine zugehörige elektrische Feldstärke einer nicht beanspruchten Elementarzelle der Randstruktur zur Veranschauli- chung einer inhomogenen Feldstärke;

Figur 5 eine vereinfachte Schnittansicht einer Elementar- zelle einer nicht beanspruchten Randstruktur zur Veranschaulichung einer lateralen Feldstärke;

Figur 6 ein Vektordiagramm der in einer nicht beanspruchten Randstruktur auftretenden elektrischen Feldstärken;

Figur 7A bis 7B9 vereinfachte Draufsichten eines Kompensa- tionsbauelements mit verschiedenen nicht beanspruchten Randstrukturen;

Figur 8 eine vereinfachte Schnittansicht einer weiteren nicht beanspruchten Randstruktur und einer aktiven Struktur;

Figur 9 eine grafische Darstellung der elektrischen Kompen- sationsfeldstärke für die aktive Struktur und eine nicht beanspruchte Randstruktur gemäß Figur 8;

Figur 10 eine vereinfachte Schnittansicht einer aktiven Struktur und einer weiteren nicht beanspruchten Randstruktur;

Figur 11 eine vereinfachte Schnittansicht einer aktiven Struktur und einer weiteren nicht beanspruchten Randstruktur mit Übergangsstruktur;

Figur 12 eine vereinfachte Schnittansicht einer aktiven Struktur und einer Randstruktur gemäß einem Ausfüh- rungsbeispiel; und

Figur 13 eine grafische Darstellung eines Kompensationsgra- des der Randstruktur gemäß Figur 12 in z-Richtung.

Figur 1 zeigt eine vereinfachte Schnittansicht einer nicht beanspruchten Randstruktur RS mit erhöhter Durchbruchspannung für ein Kompensationsbauelement. Gemäß Figur 1 befindet sich auf einem Halbleitersubstrat bzw. in einer zweiten Zone 1, welche vorzugsweise $n^+$-dotiert ist, eine Vielzahl von Halbleiterschichten $E_1$ bis $E_4$, welche gemeinsam erste Kompensationsgebiete eines ersten Leitungstyps (z.B. n) ausbilden. Eine aktive Struktur AS des Kompensationsbauelements besteht hierbei aus einer Vielzahl von Kompensationszonen 4' zum Ausbilden eines säulenförmigen zweiten Kompensationsgebiets 3', welches über eine pn-bildende Zone 7 vom zweiten Leitungstyp und eine erste Zone 6 vom ersten Leitungstyp an eine Sourceelektrode S angeschaltet ist. Ein Gateelektrode G realisiert hierbei einen eigentlich wirkenden Feldeffekttransistor zu einer nicht dargestellten weiteren Säule des Kompensationsbauelements.

Bei Kompensationsbauelementen werden in der aktiven Struktur AS unter dem eigentlichen Feldeffekttransistor p- und n-Gebiete derart nebeneinander angeordnet bzw. ineinander verschachtelt, dass sie sich im Sperrfall gegenseitig ausräumen können und dass im durchgeschalteten Zustand ein nicht unterbrochener niederohmiger Leitungspfad von der Sourceelektrode S zu einer Drainelektrode D, die mit der zweiten Zone 1 in Verbindung steht, gegeben ist. Aus Gründen der Übersichtlichkeit wird an dieser Stelle auf die Beschreibung von Kompensationsbauelementen beispielsweise in der Druckschrift DE 198 40 032 verwiesen.

Die vorliegende Erfindung nutzt nun diesen für aktive Bauelemente verwendeten Kompensationseffekt zur Realisierung von Randstrukturen mit erhöhter Durchbruchspannung, wie sie insbesondere zur Verbesserung von Randbereichen verwendet werden können. Gemäß Figur 1 besteht die Randstruktur RS in gleicher Weise wie die aktive Struktur AS aus einer Vielzahl von zweiten Rand-Kompensationsgebieten 3 vom zweiten Leitungstyp (beispielsweise p), die in den ersten Rand-Kompensationsgebieten 2 durch eine Vielzahl von Rand-Kompensationszonen 4 derart ausgebildet sind, dass eine Kompensationsfeldstärke in der Randstruktur RS geringer ist als eine Kompensationsfeldstärke in der aktiven Struktur AS des Kompensationsbauelements. Insbesondere werden bei einer Spannung die unterhalb der Durchbruchspannung des Halbleiterbauelements liegt die Ladungsträger aus den zweiten Rand-Kompensationsgebieten 3 vollständig ausgeräumt. Die zweiten Rand-Kompensationsgebiete 3 bzw. die Rand-Kompensationszonen 4 sind hierbei schwebend bzw. floatend ausgebildet, d.h. nicht angeschlossen. Eine detaillierte Erläuterung der Wirkungsweise der jeweiligen Rand-Kompensationszonen 4 auf eine jeweilige Kompensationsfeldstärke in der Randstruktur wird nachfolgend anhand der Figuren 3 bis 6 erläutert.

Zunächst wird jedoch anhand von Figur 2 ein Verfahren zur Herstellung der Randstruktur mit erhöhter Durchbruchspannung beschrieben.

Gemäß Figur 2 sind auf einem n'-dotierten Halbleitersubstrat bzw. einer zweiten Zone 1 eine erste Halbleiterschicht $E_1$ und eine zweite Halbleiterschicht $E_2$ zur Ausbildung der ersten (Rand-)Kompensationsgebiete 2 bereits epitaktisch abgeschieden, wobei sich an der Grenzfläche zwischen der ersten und zweiten Halbleiterschicht $E_1$ und $E_2$ bereits Kompensationszonen 4 befinden. Zur Realisierung einer in Figur 1 dargestellten Randstruktur wird demzufolge zunächst ein Substrat bereitgestellt und anschließend eine Vielzahl von Halbleiterschichten beispielsweise epitaktisch ausgebildet, wobei unter Verwendung einer jeweiligen Maske 5 eine Vielzahl von Kompensationszonen 4 ausgebildet werden. Alternativ zu dem vorstehend beschriebenen Verfahren sind grundsätzlich auch andere Herstellungsverfahren möglich.

Vorzugsweise wird das zu strukturierende Volumen zunächst homogen mit einer Ladungssorte, beispielsweise mit Donatoren, dotiert (Hintergrunddotierung). Anschließend wird eine Maske 5 beispielsweise als Fotolack aufgebracht und derart strukturiert, dass sich an geeigneten Stellen Öffnungen ergeben. An den Stellen der Öffnungen werden nunmehr beispielsweise mittels Ionen-Implantation (oder herkömmlicher Dotierung aus der Gasphase) beispielsweise Akzeptoren in die zweite Halbleiterschicht $E_2$ eingebracht, wodurch sich zunächst relativ eng begrenzte Kompensationszonen an der Oberfläche ergeben. Ein Teil dieser Dotierstoffkonzentration wird hierbei nicht elektrisch aktiv, da er von der Hintergrunddotierung "intrinsisch" kompensiert wird. Dieser Teil muss demzufolge zur Erzielung einer gewünschten elektrisch aktiven Dotierung vorgehalten werden.

Der in Figur 2 dargestellte Vorgang wird so oft wiederholt, bis eine genügend dicke n-Multi-Epitaxieschicht mit eingelagerten zueinander justierten und übereinander gestapelten Kompensationszonen 4 vorliegt. In einem nachfolgenden Schritt können die derart hergestellten Rand-Kompensationszonen 4 derart ausdiffundiert (sozusagen aufgeblasen) werden, bis sich in der Randstruktur RS eine Kompensationsfeldstärke einstellt, die geringer ist als eine Kompensationsfeldstärke in einem aktiven Bereich AS des Halbleiterbauelements. Bei Anlegen einer Spannung, die kleiner einer Durchbruchspannung ist, werden diese Gebiete bereits vollständig von Ladungsträgern ausgeräumt. Da gemäß Figur 2 die Randstruktur gemeinsam mit der aktiven Struktur bzw. dem Kompensationsbauelement ausgebildet werden kann, erfolgt eine thermische Ausdiffusion beispielsweise solange, bis sich zumindest die Kompensationszonen 4' in der aktiven Struktur zu einer welligen vertikalen Säule bzw. dem zweiten Kompensationsgebiet 3' zusammenschließen. Die Kompensationszonen können jedoch auch voneinander getrennt sein. Bei geeigneter Dotierung bzw. Strukturierung der Kompensationszonen 4 in der Randstruktur RS derart, dass eine Kompensationsfeldstärke in der Randstruktur RS geringer ist als eine Kompensationsfeldstärke in der aktiven Struktur AS, kann nunmehr eine verbesserte Durchbruchspannung in der Randstruktur RS auf einfache und kostengünstige Art und Weise hergestellt werden.

Hierbei gilt, dass die im gesperrten Zustand in der aktiven Struktur AS zwischen Source S und Drain D (vertikal) aufgenommene Spannung auch am Chiprand, dort aber vorwiegend in lateraler Richtung, abgebaut werden kann. Da Leistungsbauelemente oftmals bis in den Durchbruch betrieben werden, fließt, verursacht durch Stoßionisation ein sehr hoher Strom. Um das Bauteil demzufolge nicht zu zerstören, dürfen keine allzu hohen Stromdichten auftreten, d.h. der Durchbruchstrom muss sich möglichst gleichmäßig über den Chip verteilen. Diese Forderung ist aber nur dann gegeben, wenn das Zellenfeld den größten Anteil dieses Stromes führt. Da die beispielsweise in einem Randbereich ausgebildete Randstruktur gemäß Figur 1 eine höhere Durchbruchspannung aufweist als die aktive Struktur AS, können irreversible thermische Schädigungen des Halbleiterbauelements zuverlässig verhindert werden. Da darüber hinaus insbesondere bei Anwendung der beschriebenen Randstruktur HS auf Kompensationsbauelemente die grundsätzliche Struktur vergleichbar ist zur aktiven Struktur, werden üblicherweise verwendete aufwendige oberflächenpositionierte oder oberflächennahe Strukturen überflüssig, wodurch man eine durchbruchsichere Randstruktur auf besonders einfache und kostengünstige Weise erhält. Darüber hinaus sind mit der vorstehend beschriebenen Randstruktur RS auch tiefer liegende Halbleitervolumen vor Durchbruchphänomenen geschützt.

Figur 3A zeigt eine vereinfachte Schnittansicht einer nicht beanspruchten Elementarzelle der Randstruktur, wobei zunächst von einem homogen verteilten zweiten Rand-Kompensationsgebiet 3 ausgegangen wird, welches sich in einem ersten bzw. zwischen zwei Rand-Kompensationsgebieten 2 befindet. Das Halbleitersubstrat 1 ist beispielsweise $n^+$-dotiert, weshalb die ersten Rand-Kompensationsgebiete 2 eine $n^-$-Dotierung aufweisen und das zweite Rand-Kompensationsgebiet 3 eine $p^-$-Dotierung besitzt und beispielsweise in seinem oberflächennahen Bereich eine $p^+$-Dotierung aufweist.

Eine zu Figur 3A dazugehörige Nettodotierung ist in Figur 3B dargestellt. Bei einer derartigen homogenen Dotierstoffverteilung im zweiten Rand-Kompensationsgebiet 3 ergibt sich eine im Wesentlichen homogene Feldstärke $E_0$, die sich im Wesentlichen einstellen würde, wenn die Dotierstoffe in x- und y-Richtung homogen verteilt wären. Die Folge ist eine quasi eindimensionale Feldstärke, die nur in z-Richtung variiert und in Figur 3C dargestellt ist.

Figur 4A zeigt nunmehr eine vereinfachte Schnittansicht einer nicht beanspruchten Elementarzelle der Randstruktur mit vertikalen Inhomogenitäten, wie sie üblicherweise durch die Vielzahl von Rand-Kompensationszonen 4 hervorgerufen werden. Gleiche Bezugszeichen bezeichnen wiederum gleiche oder ähnliche Schichten bzw. Elemente, weshalb auf eine detaillierte Beschreibung nachfolgend verzichtet wird.

Gemäß Figur 4A besteht das zweite Rand-Kompensationsgebiet 3 nunmehr aus einer Vielzahl von Rand-Kompensationszonen 4 mit unterschiedlich starker Dotierung ($p^-$, $p^+$). Eine dazugehörige gestörte Netto-Dotierung ist in Figur 4B dargestellt. Der Einfluss der vertikalen Inhomogenität (z-Richtung) innerhalb des zweiten Rand-Kompensationsgebietes 3 kann mittels eines vertikal gerichteten Störfeldes $E_v$ beschrieben werden, das sich dem vorstehend beschriebenen quasi eindimensionalen ebenfalls vertikal gerichteten homogenen Feld $E_0$ überlagert. Figur 4C zeigt eine vereinfachte Darstellung der gestörten Feldstärke, die sich aus dieser Überlagerung der Feldstärken $E_0$ und $E_v$ ergibt.

Darüber hinaus zeigt Figur 5 eine vereinfachte Schnittansicht einer nicht beanspruchten Elementarzelle der Randstruktur zur Veranschaulichung eines lateralen Feldes $E_{tr}$, wobei gleiche Bezugszeichen wiederum gleiche oder ähnliche Schichten bezeichnen und auf eine wiederholte Beschreibung nachfolgend verzichtet wird.

Gemäß Figur 5 entsteht neben den vorstehend beschriebenen vertikalen Feldern auch ein laterales Feld $E_{tr}$, das sich dem quasi eindimensionalen Feld $E_0$ sowie dem vertikalen Feld $E_v$ ebenfalls überlagert. Dieses laterale Feld $E_{tr}$ ergibt sich im Wesentlichen aus dem gegenseitigen Ausräumen der Ladungen in den lateral angeordneten Kompensationsgebieten.

Figur 6 zeigt ein Vektordiagramm der in den Figuren 3 bis 5 beschriebenen Feldstärken, wobei eine gesamte Feldstärke $E_{tot}$ sich als Summe der Feldstärken $E_0$, $E_{tr}$ und $E_v$ ergibt. Mit $E_c$ wird nunmehr eine Kompensationsfeldstärke in der Randstruktur bezeichnet, die sich im Wesentlichen aus der vertikalen Feldstärke $E_v$ und der lateralen Feldstärke $E_{tr}$ ergibt. Demzufolge gilt:

$$E_{tot} = E_0 + E_c$$

Da sich eine derartige Kompensationsfeldstärke $E_c$ nicht nur in der Randstruktur, sondern auch im aktiven Bereich des Halbleiterbauelements bestimmen lässt, kann die Randstruktur bei geeigneter Dimensionierung der Rand-Kompensationszonen 4 unter Ausnutzung der vorstehend beschriebenen physikalischen Grundsätze nunmehr derart angepasst werden, dass eine Durchbruchspannung in der Randstruktur grundsätzlich höher ist als in der aktiven Struktur.

Die Idee kann nun einerseits darin bestehen, dass in der Randstruktur die vertikale Komponente des elektrischen Feldes und damit die vertikale Welligkeit des Kompensationsprofils reduziert wird, wodurch sich eine quasi-intrinsische Randstruktur ergibt. Hierbei wird eine Zellstruktur (z.B. hexagonal, streifenförmig, ...) bis an den Chiprand erhalten, wodurch sich Feldstärkespitzen infolge schlecht kompensierter Bereiche vermeiden lassen. Andererseits kann jedoch auch eine laterale Komponente des elektrischen Feldes reduziert werden.

Figur 7A zeigt eine Draufsicht eines Kompensationsbauelements mit nicht beanspruchter Randstruktur gemäß einem ersten Beispiel. Gleiche Bezugszeichen bezeichnen hierbei gleiche oder ähnliche Elemente, weshalb auf eine wiederholte Beschreibung nachfolgend verzichtet wird.

Gemäß Figur 7A besteht das Kompensationsbauelement aus einem Hauptelement HE bzw. einer eigentlich aktiven Struktur mit einer Vielzahl von nebeneinander angeordneten beispielsweise hexagonalen Zellstrukturen. Jede hexagonale Zellstruktur besitzt hierbei ein erstes Kompensationsgebiet 2' und ein darin ausgebildetes zweites Kompensationsgebiet 3, welches aus einer Vielzahl von Kompensationszonen 4' besteht.

Zur Realisierung eines Randbereichs RB wird gemäß Figur 7A die hexagonale Zellstruktur der aktiven Struktur bzw. des Hauptelements HE bis zum Chiprand im Wesentlichen fortgesetzt, wobei jedoch die Rand-Kompensationszonen 4 in der den Randbereich RB realisierenden Randstruktur ringförmig ausgebildet sind. Auf Grund der ringförmigen Struktur der einzelnen Rand-Kompensationszonen 4 verringert sich wegen der vorstehend beschriebenen Zusammenhänge die Kompensationsfeldstärke in der Randstruktur bzw. dem Randbereich RB gegenüber einer Kompensationsfeldstärke in der aktiven Struktur bzw. im Hauptelement HE, wodurch eine Durchbruchspannung erhöht wird. Da darüber hinaus für die Randstruktur im Wesentlichen eine 15

Fortsetzung der Zellstruktur im Hauptelement HE erfolgt, ergeben sich keine Überlappungen an einer Schnittstelle zwischen Randbereich RB und Hauptelement HE, wodurch gefährliche Feldstärkespitzen zuverlässig verhindert werden können.

Gemäß Figur 7A lassen sich bei Verwendung von derartigen Randstrukturen auf einfache Weise auch Nebenelemente NE wie beispielsweise Stromsensoren integrieren. Neben dem eigentlichen Hauptelement HE bzw. Leistungszellenfeld wird demzufolge ein Nebenelement bzw. Sensorfeld NE geschaffen, wobei die Struktur der Einzelzellen in beiden Bereichen identisch ist. Das Nebenelement NE ist also nichts anderes als ein zweites Hauptelement HE auf dem gleichen Chip, wobei allerdings die Zellenanzahl $N_{Sensor}$ im allgemeinen sehr viel kleiner ist als die des eigentlichen Leistungsteils $N_{Leistung}$. Die beiden Zellenfelder haben eine gemeinsame Drain- und Gateansteuerung. Auch die beiden Sourceansteuerungen liegen weitestgehend auf gleichem Potential (Masse), sind aber elektrisch voneinander getrennt, so dass sie als solches auch von Außen her getrennt genutzt werden können. Mit der so geschaffenen Konstellation wird das ausgekoppelte Stromverhältnis $V_I = I_{Sensor}/I_{Leistung}$ repräsentiert durch das Verhältnis $V_N$ der Zellenzahl in den beiden Bereichen ($V_N = N_{Sensor}/N_{Leistung}$). Durch Messung von $I_{Sensor}$ kann somit der Strom im Leistungsteil ausgelesen werden:

$$I_{Leistung} = V_N^{-1} * I_{Sensor}.$$

Dies ist eine sehr einfache aber effektive Methode, den Leistungsstrom zu messen ohne die eigentliche Schaltung zu beeinflussen. Da jedoch die Zuverlässigkeit der vorstehend beschriebenen Gleichung stark von Randeinflüssen abhängt, muss das Sensor- bzw. Nebenelement NE zuverlässig vom Hauptelement HE getrennt werden.

Gemäß Figur 7A dient hierzu wiederum eine Randstruktur, die als Zwischenbereich ZB zwischen dem Hauptelement HE und dem Nebenelement NE angeordnet ist und beispielsweise in gleicher Weise aufgebaut ist wie der Randbereich RB. Der durch die Randstruktur realisierte Zwischenbereich ZB wirkt demzufolge für Ladungsträger wie eine weitgehend undurchdringliche Wand, wodurch der Pfad für Ladungsträgerleitung auf das Volumen unter dem Sensorzellenfeld beschränkt ist und daher eine sehr exakte Erfassung des im Hauptelement HE fließenden Stromes $I_{Leistung}$ ermöglicht.

Das vorstehend beschriebene Sensorrandkonzept ist allgemein für beliebige Sensorbauteile anwendbar. Da es aber eine Bearbeitung des tiefliegenden Halbleitervolumens voraussetzt, ist es für konventionelle Bauteile sehr kostenintensiv. Anders stellt sich dies natürlich für die vorstehend beschriebenen Kompensationsbauelemente dar, wo ohnehin das tiefliegende Volumen bearbeitet werden muss und somit die Herstellung des Sensorrandunterbaus im gleichen Arbeitsschritt erfolgen kann.

Gemäß Figur 7A werden die Rand-Kompensationszonen in der Randstruktur ringförmig ausgebildet, wobei sie vorzugsweise eine kreisringförmige Fläche aufweisen, die konzentrisch in eine jeweilige Zellenstruktur eingepasst ist. Alternativ kommen jedoch alle möglichen ringförmigen Strukturen für das zweite Rand-Kompensationsgebiet 3 bzw. die entsprechenden Rand-Kompensationszonen 4 in Betracht und insbesondere ringförmige Vielecke wie z.B. Dreieck, Viereck, Fünfeck, Sechseck, usw. Der Vorteil einer derartigen ringförmigen Struktur besteht insbesondere darin, dass nach der thermischen Ausdiffusion eine Umfangslinie bzw. Weite für die so entstandenen Rand-Kompensationszonen 4 bzw. zweiten Rand-Kompensationsgebiete 3 der Randstruktur RS wesentlich größer ist als für die entsprechenden Kompensationszonen 4' der aktiven Struktur AS bzw. des Hauptelements HE.

Eine Zelle in der Randstruktur bzw. dem Randbereich RB oder Zwischenbereich ZB hat vom Lateralprofil der Ladungspolarität her gesehen etwa eine invertierte Struktur verglichen mit einer Zelle im aktiven Bereich bzw. Hauptelement HE. Grundsätzlich kann die Implantation bzw. Dotierung der Rand-Kompensationszonen 4 in der Randstruktur über eine beliebige Maskenstruktur erfolgen, solange nur nach Prozessende die Symmetrie der aktiven Zelle bzw. einer Zelle im Hauptelement auch für den Randbereich RB oder Zwischenbereich ZB konserviert wird und die Umfangslinie des kompensations-dominierten Bereichs innerhalb der Randstruktur gegenüber dem aktiven Bereich zunimmt.

Ferner ist die Erfindung nicht auf die in Figur 7A dargestellten Zellen beschränkt, sondern umfasst in gleicher Weise Streifenzellen oder Kombinationen davon. Die Erfindung gilt demzufolge für beliebige Anordnungen von Kompensationsgebieten, sofern wiederum die Kompensationsfeldstärke im Randbereich kleiner ist als in der aktiven Struktur des Halbleiterbauelements.

Nachfolgend sind einige nicht beanspruchte Beispiele für die Anwendung der Erfindung bei streifenförmiger Anordnung der Kompensationsgebiete dargestellt.

In den Figuren 7B1 und 7B2 sind vereinfachte Draufsichten von nicht beanspruchten Beispielen dargestellt, wobei eine Streifenbreite und -Abstand im Randbereich RB kleiner ausgelegt als im aktiven Teil bzw. Hauptelement HE des Bauelements. Dadurch reduziert sich die Querfeldkomponente des Kompensationsfeldes. Das Prinzip des Streifenlayouts bleibt aber auch im Randbereich enthalten.

Gemäß Figuren 7B3 und 7B4 wird bei einem weiteren nicht beanspruchten Beispiel im Randbereich RB anstelle des Streifenlayouts ein Rasterlayout gewählt, wobei das Kompensationsfeld auch hier wieder kleiner ausgelegt wird als im aktiven Teil des Bauelements.

Figur 7B5 zeigt eine vereinfachte Draufsicht eines weiteren nicht beanspruchten Beispiels. Da es im Übergangsbereich zwischen den schmalen Streifenenden und den Streifenseiten (also z.B. nahe der Ecke des aktiven Baulementbereichs) zu Feldüberhöhungen aufgrund des Symmetriebruchs an dieser Stelle kommt, kann es sinnvoll sein, das Kompensationsfeld in diesem Bereich nicht durch Streifen sondern durch ein Rasterlayout abzusenken. Ein Raster hat den Vorteil, dass Feldspitzen an den Ecken durch geeignete Lage der Kompensationsgebiete besser ausgeglichen werden können, als dies mit Streifen möglich wäre.

Figuren 7B6 und 7B7 zeigt eine Draufsicht von weiteren nicht beanspruchten Beispielen, wobei ein Hauptelement HE mit Streifenlayout im aktiven Teil des Bauelements und eine Randstruktur bzw. ein Randbereich RB mit gleichmäßiger Verteilung der Dotierstoffe vorliegt. Die Dotierung kann dabei sehr schwach n, sehr schwach p oder tatsächlich intrinsisch sein. In allen drei Fällen ist das Kompensationsfeld null.

Ferner muss bei den weiteren nicht beanspruchten Beispielen gemäß Figuren 7B8 und 7B9 auch ein Streifenlayout im Randbereich RB nicht notwendigerweise homogen in vertikaler Richtung zu sein. So ist es zum Beispiel möglich, im oberen Bereich des Randbereichs ein anderes Streifenraster als im unteren Bereich zu wählen (Figur 7B8), oder nur den oberen (oder unteren) Teil des Randbereichs im Streifenlayout zu erstellen und den anderen Teil mit einem Rasterlayout (Figur 7B9) zu versehen.

Auch beim Streifenlayout sind alle Kombinationen aller genannten Layouts des Randbereichs möglich, solange dadurch das Kompensationsfeld unter den Wert zu senken, der in der aktiven Struktur des Bauelements erreicht wird.

Insbesondere lässt sich durch beispielsweise ringförmig ausgebildete Rand-Kompensationszonen 4 die Durchbruchspannung im Randbereich RB wesentlich erhöhen, wobei darüber hinaus in einem Zwischenbereich ZB zu beispielsweise einem Sensorelement bzw. Nebenelement NE sogenannte obere Gießkanneneffekte wirksam bekämpft werden können. Grenzen nämlich mehrere solcher Randstrukturzellen in einem Zwischenbereich ZB aneinander, so bilden sie für Elektronen, die in einer benachbarten aktiven Zelle geführt werden, eine durchgängige p-lastige also quasi-undurchdringliche Wand.

Im Gegensatz zum vorstehend beschriebenen oberen Gießkanneneffekt kann jedoch auch ein sogenannter "tiefer Gießkanneneffekt" auftreten.

Ladungsträger, die sich im Sensorelement bzw. Nebenelement NE nahe der Randstruktur Richtung Substrat bewegen, können, sobald sie das untere Ende des Säulenaufbaus erreicht haben, lateral in das senkrecht unter der Randstruktur liegende Volumen fließen. Damit vergrößert sich aber der effektive Leistungsquerschnitt $F_Q$ des Sensors. Die Gleichung

$$I_{Leistung} = V_F^{-1} * I_{Sensor}$$

mit
$V_F$ = aktive Fläche $F_{Sensor}$ des Sensors in Draufsicht / aktive Fläche $F_{Leistung}$ des Leistungsteils in Draufsicht
ist wegen $F_Q$ ungleich Fsensor nicht mehr gültig.

Der tiefe Gießkanneneffekt kann nur schwer verhindert werden, da aus fertigungstechnischer Sicht das tiefliegende Volumen oft nicht bearbeitbar ist. Es besteht jedoch die Möglichkeit, im oberen Volumen des Nebenelements NE den Strompfad weiter einzugrenzen, als dies durch $F_{Sensor}$ vorgegeben wird. Dadurch kann ein Ausgleich zum tiefen Gießkanneneffekt geschaffen werden. Für einen Ausgleich zum tiefen Gießkanneneffekt wäre deshalb beispielsweise denkbar, dass die Randstruktur des Nebenelements NE in der untersten Ebene weiter in Richtung aktives Sensorgebiet versetzt wird, als dies in höher gelegenen Ebenen der Fall ist. Während also im oberen Teil des Sensors die Randstruktur einen Stromleitquerschnitt vorgibt, der identisch zu $F_{Sensor}$ ist, wird der Strompfad in der untersten Ebene auf eine Fläche kleiner $F_{Sensor}$ eingegrenzt. Die Stromeinschnürung muss natürlich nicht notgedrungen in der untersten Ebene stattfinden, sie kann auch in einer höher liegenden Ebene erfolgen, oder aber sie wird auf mehreren Ebenen verteilt, wie nachfolgend im Einzelnen beschrieben wird.

Figur 8 zeigt eine vereinfachte Schnittansicht einer nicht beanspruchten Randstruktur RS und einer aktiven Struktur AS gemäß einem weiteren Beispiel, wobei gleiche Bezugszeichen gleiche oder ähnliche Schichten bzw. Elemente bezeichnen und auf eine wiederholte Beschreibung nachfolgend verzichtet wird.

Gemäß Figur 8 besteht eine Elementarzelle in einer aktiven Struktur AS aus sechs übereinander liegenden Kompensationszonen 4', die gemeinsam ein säulenförmiges Kompensationsgebiet 3' vom zweiten Leitungstyp (z.B. p) realisieren. Demgegenüber besteht gemäß Figur 8 eine Elementarzelle der Randstruktur RS aus sechs sehr schmalen Rand-Kompensationszonen 4 in einem oberen Bereich I und sechs weiteren Rand-Kompensationszonen 4 in einem Bereich II, die lediglich eine halbe laterale Strukturbreite der Zonen im Bereich I aufweisen, jedoch ansonsten eine gleiche Breite wie die Kompensationszonen 4' in der aktiven Struktur AS aufweisen. Gemäß Figur 8 kann demzufolge eine Variation der Größe der Vielzahl von Rand-Kompensationszonen 4 in einer x-, einer y- und einer z-Richtung gleichmäßig aber auch unterschiedlich erfolgen, wodurch wiederum eine Durchbruchsicherheit im Randbereich oder Zwischenbereich erhöht werden kann.

Zur Verdeutlichung der Auswirkungen der in Figur 8 dargestellten Randstruktur RS wird nachfolgend ein in Figur 9 dargestellter elektrischer Feldverlauf über eine Bauelementetiefe z diskutiert.

Mit AS ist hierbei eine jeweilige Kurve der elektrischen Kompensationsfeldstärke $E_C$ bei einer vorbestimmten Bauelementtiefe z dargestellt, die in der aktiven Struktur vorherrscht. In gleicher Weise bezeichnet RS eine jeweilige Kurve der elektrischen Kompensationsfeldstärke $E_C$ bei einer vorbestimmten Bauelementtiefe z, die in der Randstruktur vorherrscht.

Gemäß Figur 9 ergibt sich demzufolge aufgrund der Verdoppelung der Kompensationszonen eine Halbierung der Wellenlänge (bzw. Verdoppelung der Welligkeit), wobei sowohl die Wellenmaxima als auch -minima des resultierenden Feldstärkeverlaufs reduziert sind. Demzufolge erhält man im Bereich I aufgrund der vertikalen Strukturierung eine gegenüber der aktiven Struktur verbesserte Durchbruchspannung. In ähnlicher Weise erhöht sich auch die Durchbruchspannung im Bereich II aufgrund der lateralen Strukturierung. Durch die laterale Aufteilung verringern sich die vorstehend beschriebene lateralen Feldkomponenten wodurch sich wiederum die Wellenmaxima und - minima des resultierenden Feldstärkeverlaufs bei gleichbleibender Wellenanzahl verringern.

Gemäß Figur 8 sind die Rand-Kompensationszonen 4 nur in bestimmten Bereichen I und II einer z-Richtung an jeweilige Anforderungen angepasst. Eine derartige Anpassung kann jedoch auch in einer x- und y-Richtung erfolgen.

Ferner sind die Vielzahl von Rand-Kompensationszonen 4 sowohl in x-, y- und z-Richtung gemäß Figur 8 in einem vorbestimmten Raster ausgebildet. Es kann jedoch auch in jeder dieser Richtungen zumindest teilweise eine (nicht dargestellte) Auflösung des Rasters erfolgen, wodurch sich weitere flexible Anpassungen zur Reduzierung einer Kompensationsfeldstärke in der Randstruktur RS realisieren lassen. Beispielsweise können in einer oder mehreren Aufbauebenen die jeweiligen Kompensationszonen so angeordnet werden, dass ein Raster beispielsweise in z-Richtung nicht mehr vorhanden ist. In gleicher Weise kann eine derartige Auflösung eines Rasters auch in x- und y-Richtung erfolgen und Mischformen mit einer Rasterauflösung in z-Richtung durchgeführt werden, wodurch sich drei weitere Reduzierungen einer Kompensationsfeldstärke in der Randstruktur ergeben können. Bei Spannungen, die unterhalb der Durchbruchspannung liegen ergibt sich hierbei ein vollständiges Ausräumen der Ladungtsträger insbesondere aus den Rand-Kompensationsgebieten 3.

Gemäß Figur 8 ergibt sich eine Reduzierung der elektrischen Kompensationsfeldstärke in der Randstruktur durch eine Verkleinerung der Abstände bzw. Verringerung der Schichtdicken für die Kompensationszonen 4. Es kann jedoch in gleicher Weise auch für die gesamte Randstruktur RS eine geringere Gesamtdotierung als für die aktive Struktur AS des Halbleiterbauelements verwendet werden. Ferner kann eine Absenkung der elektrischen Kompensationsfeldstärke auch dadurch erreicht werden, dass in der Randstruktur RS eine (nicht dargestellte) Grabenstruktur ausgebildet wird, die einen Teil der Dotierung in der Randstruktur RS entfernt. Wiederum ergibt sich dadurch eine erhöhte Durchbruchsfestigkeit der Randstruktur.

Figur 10 zeigt eine vereinfachte Schnittansicht einer aktiven Struktur und einer nicht beanspruchten Randstruktur gemäß einem weiteren Beispiel, wobei eine vorstehend beschriebene Mischform zwischen gleich großen und unterschiedlich großen Kompensationszonen 4 bei gleichem Raster dargestellt ist.

Gemäß Figur 10 besitzt ein Tiefenaufbau der Randstruktur RS nunmehr fünf verschiedene Bereiche, in denen die Kompensationszonen 4 derart ausgebildet sind, dass eine Kompensationsfeldstärke $E_C$ in der Randstruktur RS kleiner ist als eine Kompensationsfeldstärke in der aktiven Struktur AS. Es sei hierbei darauf hingewiesen, dass die in den vorstehend beschriebenen Ausführungsbeispielen jeweiligen Rand-Kompensationszonen 4 jeweils unterschiedliche Kompensationsgrade K aufweisen, die sich beispielsweise durch

$$(p\text{-Dotierung} - n\text{-Dotierung})/n\text{-Dotierung}$$

ergeben.

Figur 11 zeigt eine vereinfachte Schnittansicht einer aktiven Struktur AS und einer nicht beanspruchten Randstruktur RS mit einer Übergangsstruktur ÜS gemäß einem weiteren Beispiel, wobei gleiche Bezugszeichen wiederum gleiche oder entsprechende Elemente bezeichnen und auf eine wiederholte Beschreibung nachfolgend verzichtet wird.

Zur weiteren Anpassung der Randstruktur RS an eine jeweilige aktive Struktur AS kann demzufolge die Randstruktur RS am direkten Übergang zur aktiven Struktur AS eine Übergangsstruktur ÜS aufweisen, die sich von der restlichen Randstruktur RS unterscheidet. Gemäß Figur 11 besitzt die Übergangsstruktur ÜS ein an die aktive Struktur AS angepasstes spezielles Tiefenprofil mit unterschiedlich dimensionierten Rand-Kompensationszonen 4, während die restliche Randstruktur jeweils aus gleichen Elementarzellen mit beispielsweise gleichförmigen Rand-Kompensationszonen 4 besteht. Der Nachteil eines Wechsels in der Zellstruktur besteht nämlich darin, dass am Übergang zwischen beispielsweise einer aktiven Struktur AS und einer Randstruktur RS Inhomogenitäten infolge von Nachbarwechselwirkungen auftreten, die zu Frühdurchbrüchen, Schwingungserscheinungen in dynamischen Schaltungen oder strommäßigen Überbelastungen solcher Orte führen können.

Bei zueinander symmetrischen Zellen ist der elektrische Übergang identisch mit der geometrischen Trennebene, fällt also exakt mit der Symmetrieebene zusammen, wie sie in Figur 11 zwischen den beiden rechten Rand-Kompensationsgebieten 3 auftritt. Beim Übergang zwischen zueinander nicht symmetrischen Zellen wie z.B. zwischen der Zelle der aktiven Struktur AS und der Zelle der Übergangsstruktur ÜS ist dies anders. Der elektrische Übergang fällt hierbei nicht mit der Zelltrennebene zusammen, sondern die Spiegelladungen zum zweiten Rand-Kompensationsgebiet 3 werden zum Teil an Orten gefunden, die geometrisch eigentlich der Nachbarzelle zuzuordnen sind. Es handelt sich also hierbei um einen Durchgriff zum Nachbarn. Ein derartiger Durchgriff erhöht immer die Feldstärke. Mit einer solchen Inhomogenitätsstelle kann es also zu Feldspitzen kommen, welche zu den oben genannten Phänomenen führen.

Gemäß Figur 11 können derartige Zellnachbar-Wechselwirkungen bzw. Durchgriffe zum Nachbarn durch sogenannte Übergangsstrukturen ÜS in der Randstruktur verhindert bzw. abgeschwächt werden, wobei die jeweiligen Kompensationszonen derart angepasst werden, dass sich wiederum eine minimale elektrische Kompensationsfeldstärke einstellt und Feldspitzen verhindert werden, wobei sich ein vollständiges Ausräumen von Ladungsträgern in den Kompensationsgebieten vor Erreichen der Durchbruchspannung einstellt.

Jede von einer symmetrischen Zellauslegung abweichende Dotierstoffverteilung geht in die Ausprägung des sogenannten Nachbardurchgriffs ein. Der Gesamt-Kompensationsgrad $k_{ges}$ einer Zelle ist definiert als

$$k_{ges} = \{2 * [(\text{Anzahl n-Ladungen}) - (\text{Anzahl p-Ladungen})]\} / [(\text{Anzahl n-Ladungen}) + (\text{Anzahl p-Ladungen})]$$

im spannungsaufnehmenden Volumen für eine Zelle. Dabei gehen in die Aufsummierung nur diejenigen Ladungen ein, die der jeweiligen Zelle geometrisch zugeordnet werden (es gilt also nicht die elektrisch korrekte Zuordnung, in der ein Durchgriff berücksichtigt wäre).

k kann auch tiefenaufgelöst angegeben werden:

$$k(z) = \{2 * [(\text{Anzahl n-Ladungen}) - (\text{Anzahl p-Ladungen})]\} / [(\text{Anzahl n-Ladungen}) + (\text{Anzahl p-Ladungen})]$$

in der Tiefe z mit der Schichtdicke dz.

Ferner gilt $k_{ges}$ = $\text{Integral}_{\text{gesamte spannunsaufnehmende}}$ Tiefe über(k(z)dz) Üblicherweise ist k(z) variabel gehalten:

c) Zum einen geht hier ein parasitärer Effekt ein, der sich aus der welligen Struktur des zweiten Rand-Kompensationsgebietes 3 ergibt. Infolge der Welligkeit nimmt die gesperrte Spannung drastisch ab gegenüber einem geglätteten Profil.

d) Andererseits wird dem zweiten Rand-Kompensationsgebiet üblicherweise ein Dotiergradient aufgeprägt (variables Tiefendotierprofil), welcher im Zusammenwirken mit der homogenen Hintergrunddotierung einen bei negativen Werten beginnenden und mit z stetig ansteigenden tiefenaufgelösten Kompensationsgrad bewirkt. Mit dieser Methode erreicht man, dass das elektrische Feld seinen höchsten Wert vorzugsweise auf halber Höhe des spannungsaufnehmenden Volumens erreicht. Der Durchbruch wird also an diesen Ort verlegt (dachförmiger E-FeldVerlauf) (siehe auch Figur 9). Damit ergibt sich im Durchbruch eine stabilisierende Wirkung, da auf Grund der dynamischen Dotierung (Kirk-Effekt) der Durchbruch gleichmäßig über viele Kompensationszonen verteilt wird und sich dadurch die Robustheit der Randstruktur verbessert.

Figur 12 zeigt eine vereinfachte Schnittansicht einer aktiven Struktur AS mit einer Übergangsstruktur ÜS gemäß einem bevorzugten Ausführungsbeispiel der Erfindung, wobei gleiche Bezugszeichen gleiche oder ähnliche Schichten bzw. Elemente wie in den vorhergehenden Beispielen bezeichnen und auf eine wiederholte Beschreibung nachfolgend verzichtet wird.

Gemäß Figur 12 besitzt eine Zelle in der aktiven Struktur AS sechs Kompensationszonen 4' mit unterschiedlichen Kompensationsgraden von +30% bis -20%. Gemäß Figur 12 kann nunmehr eine Übergangsstruktur ÜS einen Übergang von zwei unterschiedlichen Zellkonzepten, (welcher über Nachbardurchgriff tendenziell zu verfrühten Durchbrüchen führt) spannungsmäßig derart entschärfen, dass eine Robustheit einer entsprechend ausgelegten Randstruktur verbessert ist. Trennt diese Übergangsstruktur eine aktive Struktur AS von beispielsweise einem Randbereich oder auch von einem Gatepadunterbau, so erreicht man damit, dass der Durchbruch von den Zellen der Übergangsstruktur weg in das Zellenfeld der aktiven Struktur AS verlegt wird, wo er sich gleichmäßig verteilen kann. Dies bewirkt in der Regel, dass die Stromtragfähigkeit im Durchbruchsverhalten stark zunimmt.

Zur spannungsmäßigen Stabilisierung einer solchen Übergangsstruktur wird nunmehr der Nachbardurchgriff gezielt genutzt:

In der Regel unterscheiden sich die beiden an einem Übergang beteiligten Zellen in ihrer Durchbruchspannung $U_{BV}$. Diejenige Zelle mit niedrigerem $U_{BV}$ werde im Folgenden mit Durchbruchszelle bezeichnet, die zweite hingegen mit Stabilisierungszelle bzw. Zelle der Übergangsstruktur. Es wird nun vorgeschlagen, die Durchbruchs- und Stabilisierungszelle nicht, wie bisher üblich, mit gleichem oder sehr ähnlichem Kompensationsprofil k(z) auszustatten, sondern beide Zellen zu einer Einheit zusammenzulegen, welche ein weitestgehend homogenes k-Profil aufweist. Vorteilhafterweise wird hierbei k(z)=0 angestrebt.

Hierzu wird mindestens eine Stabilisierungszelle bzw. Zelle in der Übergangsstruktur ÜS im tiefenaufgelösten Kompensationsprofil polaritätsmäßig invertiert gegenüber der Durchbruchzelle bzw. der Zelle der aktiven Struktur AS. Gemäß Figur 12 besitzen demnach die Rand-Kompensationszonen 4 der Zelle der Übergangsstruktur ÜS die invertierten Kompensationsgrade der benachbarten Zelle der aktiven Struktur AS. Genauer gesagt variieren die Rand-Kompensationszonen 4 vom oberflächennahen Bereich zum Substrat 1 hin von -30% bis +20%. Die Summe mit k(z) für einen jeweiligen Übergangsbereich von der aktiven Struktur zur Randstruktur RS ergibt sich demzufolge zu:

$$k(z) + k_s(z) \approx 0.$$

Von Welligkeitserscheinungen wird bei dieser Betrachtung abgesehen, da sie sich nur schwer beeinflussen lassen und die genannte Stabilisierungswirkung nicht beeinflussen.

Betrachtet man nun die Durchbruchszelle und die Stabilisierungszelle mit deren Nachbarwechselwirkungen aufeinander als Einheit (wobei eigentlich alle Nachbarn der Stabilisierungszelle mit einbezogen werden müssten), so ergibt sich ein nahezu homogenes Tiefendotierprofil. Das elektrische Feld innerhalb dieser Einheit zeigt einen waagrechten Verlauf mit der Tiefe z, was somit insbesondere für den Zellkonzeptübergang bedeutet, dass die Durchbruchspannung massiv gesteigert wird.

Technologisch kann eine derartige Übergangsstruktur ÜS beispielsweise dadurch erreicht werden, dass die Implantationsöffnungen in den einzelnen Halbleiterschichten $E_1$ bis $E_n$ für die Stabilisierungszellen bzw. Zellen der Übergangsstruktur ÜS von oben nach unten immer größer werden, während für alle anderen Zellen (z.B. der aktiven Struktur AS) der gegenläufige Trend gilt. Implantiert wird dann in jeder Halbleiterschichtebene mit gleicher, an die Hintergrunddotierung und die Implantationsöffnungen angepasster Dosis.

Demzufolge kann ein tiefenaufgelöstes Kompensationsprofil der Vielzahl von schwebenden zweiten Rand-Kompensationsgebieten 3 in der Übergangsstruktur ÜS an die Nachbarzellen angepasst werden, wobei vorzugsweise eine Invertierung des Kompensationsprofils bzw. der jeweiligen Kompensationsgrade durchgeführt wird.

Figur 13 zeigt eine grafische Darstellung eines tiefenaufgelösten Kompensationsprofils für eine jeweilige Zelle in einer aktiven Struktur AS und einer Zelle der vorstehend beschriebenen Übergangsstruktur ÜS.

Gemäß Figur 12 wurde nur eine Zellreihe als Stabilisierungsstruktur bzw. Übergangsstruktur ÜS in der Randstruktur RS beschrieben. Es lassen sich jedoch auch mehrere Zellen hinter einer jeweiligen Schwachstelle entsprechend anpassen, wobei sich die Übergangsstruktur ÜS in der Randstruktur in zweiter bis n-ter Ordnung fortsetzt. Auf diese Weise können auch Wechselwirkungen zweiter bis n-ter Ordnung für die übernächsten usw. Nachbarn einer Übergangsstruktur ÜS positiv beeinflusst werden. Auf diese Weise kann nicht nur die unmittelbare Schwachstelle, sondern ein ganzer Bereich im näheren Umfeld stabilisiert werden, wodurch sich eine kontinuierliche Verbesserung der Durchbruchsfestigkeit in der Randstruktur realisieren lässt.

Die vorstehend beschriebene Erfindung wurde insbesondere anhand von Kompensationsbauelementen beschrieben. Sie ist jedoch nicht darauf beschränkt, sondern umfasst in gleicher Weise Leistungsbauelemente oder irgendwelche Halbleiterbauelemente, in denen durchbruchsichere Randstrukturen benötigt werden. In gleicher Weise beschränkt sich die vorliegende Erfindung nicht auf die beschriebenen p- und n-Dotierungen in einem Si-Halbleitersubstrat, sondern bezieht sich in gleicher Weise auf entsprechende Dotierprofile und alternative Halbleitermaterialien.

## Patentansprüche

1. Halbleiterbauelement mit einer aktiven Struktur (AS), die einen sperrenden pn-Übergang in einem Halbleitersubstrat (1) aufweist, mit
einer ersten Zone (6) eines ersten Leitungstyps, die mit einer ersten Elektrode (S) verbunden ist und an eine den sperrenden pn-Übergang bildende Zone (7) eines zweiten, zum ersten Leitungstyp entgegengesetzten Leitungstyps angrenzt, die ebenfalls mit der ersten Elektrode (S) verbunden ist, und mit einer zweiten Zone (1) des ersten Leitungstyps, die mit einer zweiten Elektrode (D) verbunden ist, wobei im Bereich zwischen der ersten Zone (7) und der zweiten Zone (1) erste und zweite Kompensationsgebiete (2', 3') des ersten und zweiten Leitungstyps ineinander verschachtelt sind, und
mit einer Randstruktur (RS), mit
einer Vielzahl von ersten Rand-Kompensationsgebieten (2) des ersten Leitungstyps (n); und
einer Vielzahl von schwebenden zweiten Rand-Kompensationsgebieten (3) des zweiten Leitungstyps (p), die eine Vielzahl von Rand-Kompensationszonen (4) aufweisen und mit den ersten Rand-Kompensationsgebieten (2) derart verschachtelt sind,
dass die zweiten Rand-Kompensationsgebiete (3) vor Erreichen einer Durchbruchspannung vollständig von Ladungsträgern ausgeräumt werden, wobei die Randstruktur (RS) eine Übergangsstruktur (ÜS) aufweist, die sich von der restlichen Randstruktur (RS) unterscheidet und eine Vielzahl von Rand-Kompensationszonen aufweist
**dadurch gekennzeichnet, dass** die Kompensationsgrade der Rand-Kompensationszonen (4) der Übergangsstruktur einerseits und der korrespondierenden Kompensationszonen (4') der aktiven Struktur andererseits invertiert und nicht gleich sind.

2. Halbleiterbauelement nach Patentanspruch 1, **dadurch gekennzeichnet, dass** die Übergangsstruktur (ÜS) eine Vielzahl von schwebenden zweiten Rand-Kompensationsgebieten (3) mit invertiertem tiefenaufgelösten Kompensationsprofil zu ihren benachbarten Kompensationsgebieten (3') in der aktiven Struktur (AS) aufweist.

3. Halbleiterbauelement nach Patentanspruch 1 oder 2,
**dadurch gekennzeichnet, dass** die Randstruktur (RS) einen Randbereich (RB) des Halbleiterbauelements darstellt.

4. Halbleiterbauelement nach einem der Patentansprüche 1 bis 3, **dadurch gekennzeichnet, dass** die Randstruktur (RS) einen Zwischenbereich (ZB) zwischen einem Hauptelement (HE) und einem Nebenelement (NE) des Halbleiterbauelements darstellt.

5. Halbleiterbauelement nach einem der Patentansprüche 1 bis 4, **dadurch gekennzeichnet, dass** die Randstruktur (RS) eine Zellenstruktur aufweist, die im Wesentlichen einer Zellenstruktur der aktiven Struktur (AS) des Halbleiterbauelements entspricht.

6. Halbleiterbauelement nach Patentanspruch 5,
**dadurch gekennzeichnet, dass** die Zellenstruktur im Wesentlichen ein Vieleck darstellt.

7. Halbleiterbauelement nach einem der Patentansprüche 1 bis 6, **dadurch gekennzeichnet, dass** die Vielzahl von Rand-Kompensationszonen (4) ringförmig ausgebildet sind.

8. Halbleiterbauelement nach Patentanspruch 7,
**dadurch gekennzeichnet, dass** die Vielzahl von Rand-Kompensationszonen (4) ringförmige Vielecke darstellen.

9. Halbleiterbauelement nach einem der Patentansprüche 1 bis 8, **dadurch gekennzeichnet, dass** die Vielzahl von Rand-Kompensationszonen (4) unterschiedliche Kompensationsgrade (K) aufweisen.

10. Halbleiterbauelement nach einem der Patentansprüche 1 bis 9, **dadurch gekennzeichnet, dass** die Vielzahl von Rand-Kompensationszonen (4) nur in bestimmten Bereichen einer z-Richtung einen invertierten Kompensationsgrad (K) aufweisen.

11. Halbleiterbauelement nach einem der Patentansprüche 1 bis 10, **dadurch gekennzeichnet, dass** eine Variation der Größe der Vielzahl von Rand-Kompensationszonen (4) in x-, y- und z-Richtung gleichmäßig und/oder verschieden erfolgt.

12. Halbleiterbauelement nach einem der Patentansprüche 1 bis 11, **dadurch gekennzeichnet, dass** die Vielzahl von Rand-Kompensationszonen (4) in x-, y- und z-Richtung mit oder ohne ein Raster ausgebildet sind.

13. Halbleiterbauelement nach einem der Patentansprüche 1 bis 12, **dadurch gekennzeichnet, dass** eine Gesamtdotierung im Bereich der Randstruktur (RS) geringer ist als in der aktiven Struktur (AS).

14. Halbleiterbauelement nach einem der Patentansprüche 1 bis 13, **dadurch gekennzeichnet, dass** eine Grabenstruktur einen Teil der Dotierung in der Randstruktur (RS) entfernt.

15. Verfahren zur Herstellung eines Halbleiterbauelements nach einem der Patentansprüche 1 bis 14, mit den Schritten:

a) Ausbilden einer Vielzahl von Halbleiterschichten ($E_1$ bis $E_4$) zur Realisierung der ersten Rand-Kompensationsgebiete (2);
b) Ausbilden einer Vielzahl von Masken (5) für die jeweiligen Halbleiterschichten ($E_1$ bis $E_4$); und
c) Ausbilden der Vielzahl von Rand-Kompensationszonen (4) mittels der Vielzahl von Masken (5) in den jeweiligen Halbleiterschichten ($E_1$ bis $E_4$) zur Realisierung des zweiten Rand-Kompenpensationsgebietes (3), wobei das Ausbilden der Rand-Kompensationszonen (4) mittels Ionen-Implantation und nachfolgender thermischer Ausdiffusion derart durchgeführt wird, dass sich die invertierten tiefenaufgelösten Kompensationsgrade ergeben.

16. Verfahren nach Patentanspruch 15, wobei das Ausbilden der Vielzahl von Halbleiterschichten ($E_1$ bis $E_4$) ein epitaktisches Abscheiden darstellt.

17. Verfahren nach Patentanspruch 15 oder 16, wobei durch Änderung einer Implantationsdosis, einer Öffnung in der Maske und/oder einer Zeitdauer der thermischen Ausdiffusion der Kompensationsgrad (K) in den Rand-Kompensationszonen (4) eingestellt wird.

**Claims**

1. Semiconductor component comprising an active structure (AS) having a blocking pn junction in a semiconductor substrate (1), comprising
a first zone (6) of a first conduction type, which is connected to a first electrode (S) and adjoins a zone (7) - forming the blocking pn junction - of a second conduction type, which is opposite to the first conduction type, said zone likewise being connected to the first electrode (S), and comprising
a second zone (1) of the first conduction type, which is connected to a second electrode (D), wherein first and second compensation regions (2', 3') of the first and second conduction types are interleaved in one another in the region between the first zone (7) and the second zone (1), and
comprising an edge structure (RS), comprising a multiplicity of first edge compensation regions (2) of the first conduction type (n); and
a multiplicity of floating second edge compensation regions (3) of the second conduction type (p), which have a multiplicity of edge compensation zones (4) and are interleaved with the first edge compensation regions (2) in such a way that the second edge compensation regions (3) are fully depleted of charge carriers before a breakdown voltage is reached, wherein the edge structure (RS) has a transition structure (ÜS) that differs from the rest of the edge structure (RS) and has a multiplicity of edge compensation zones,
**characterized in that** the degrees of compensation of the edge compensation zones (4) of the transition structure, on the one hand, and of the corresponding compensation zones (4') of the active structure, on the other hand, are inverted and not equal.

2. Semiconductor component according to Patent Claim 1,
**characterized in that** the transition structure (ÜS) has a multiplicity of floating second edge compensation regions (3) having an inverted depth-resolved compensation profile with respect to their adjacent compensation regions (3') in the active structure (AS).

3. Semiconductor component according to Patent Claim 1 or 2,
**characterized in that** the edge structure (RS) constitutes an edge region (RB) of the semiconductor component.

4. Semiconductor component according to any of Patent Claims 1 to 3,
**characterized in that** the edge structure (RS) constitutes an intermediate region (ZB) between a primary element (HE) and a secondary element (NE) of the semiconductor component.

5. Semiconductor component according to any of Patent Claims 1 to 4, **characterized in that** the edge structure (RS) has a cell structure that substantially corresponds to a cell structure of the active structure (AS) of the semiconductor component.

6. Semiconductor component according to Patent Claim 5, **characterized in that** the cell structure substantially constitutes a polygon.

7. Semiconductor component according to any of Patent Claims 1 to 6, **characterized in that** the multiplicity of edge compensation zones (4) are embodied in a ring-shaped fashion.

8. Semiconductor component according to Patent Claim 7, **characterized in that** the multiplicity of edge compensation zones (4) constitute ring-shaped polygons.

9. Semiconductor component according to any of Patent Claims 1 to 8, **characterized in that** the multiplicity of edge compensation zones (4) have different degrees of compensation (K).

10. Semiconductor component according to any of Patent Claims 1 to 9, **characterized in that** the multiplicity of edge compensation zones (4) have an inverted degree of compensation (K) only in specific regions in a z direction.

11. Semiconductor component according to any of Patent Claims 1 to 10, **characterized in that** a variation of the size of the multiplicity of edge compensation zones (4) is effected uniformly and/or differently in the x, y and z directions.

12. Semiconductor component according to any of Patent Claims 1 to 11, **characterized in that** the multiplicity of edge compensation zones (4) are formed with or without a grid in the x, y and z directions.

13. Semiconductor component according to any of Patent Claims 1 to 12, **characterized in that** a total doping is lower in the region of the edge structure (RS) than in the active structure (AS).

14. Semiconductor component according to any of Patent Claims 1 to 13, **characterized in that** a trench structure removes a part of the doping in the edge structure (RS).

15. Method for producing a semiconductor component according to any of Patent Claims 1 to 14, comprising the following steps:

    a) forming a multiplicity of semiconductor layers ($E_1$ to $E_4$) for realizing the first edge compensation regions (2);
    b) forming a multiplicity of masks (5) for the respective semiconductor layers ($E_1$ to $E_4$); and
    c) forming the multiplicity of edge compensation zones (4) by means of the multiplicity of masks (5) in the respective semiconductor layers ($E_1$ to $E_4$) for realizing the second edge compensation region (3), wherein the process of forming the edge compensation zones (4) is carried out by means of ion implantation and subsequent thermal outdiffusion in such a way that the inverted depth-resolved degrees of compensation arise.

16. Method according to Patent Claim 15, wherein the process of forming the multiplicity of semiconductor layers ($E_1$ to $E_4$) constitutes an epitaxial deposition.

17. Method according to Patent Claim 15 or 16, wherein the degree of compensation (K) in the edge compensation zones (4) is set by changing an implantation dose, an opening in the mask and/or a time duration of the thermal outdiffusion.

**Revendications**

1. Composant à semiconducteur comprenant une structure (AS) active, qui a jonction pn bloquante dans un substrat (1) semiconducteur, comprenant
une première zone (6) d'un premier type de conductivité, qui est reliée à une première électrode (S) et qui est voisine d'une zone (7) formant la jonction pn bloquante d'un deuxième type de conductivité opposé au premier type de conductivité, laquelle est reliée également à la première électrode (S), et comprenant une deuxième zone (1) du premier type de conductivité, qui est reliée à une deuxième électrode (D) des premier et deuxième domaines (2', 3') de compensation du premier et du deuxième types de conductivité étant emboîtés l'un dans l'autre dans la région comprise entre la première zone (7) et la deuxième zone (1), et
comprenant une structure (RS) de bord comprenant une pluralité de premiers domaines (2) de compensation de bord du premier type (n) de conductivité ; et
une pluralité de deuxièmes domaines de compensation de bord flottants du deuxième type (p) de conductivité, qui comportent une pluralité de zones (4) de compensation de bord et qui sont emboîtés avec les premiers domaines (2) de compensation de bord, de manière à ce que les deuxièmes domaines (3) de compensation de bord soient débarrassés complètement de porteurs de charge avant d'atteindre une tension de claquage, la structure (RS) de bord ayant une structure (ÜS) de transition, qui se distingue du reste de la structure (RS) de bord, et ayant une pluralité de zones de compensation de bord, **caractérisé en ce que** les degrés de compensation des zones (4) de compensation de bord de la structure de transition d'une part et des zones (4') de compensation correspondantes de la structure active d'autre part sont inversés et ne sont pas égaux.

**2.** Composant à semiconducteur suivant la revendication 1,
**caractérisé en ce que** la structure (ÜS) de transition a une pluralité de deuxièmes domaines (3) de compensation de bord flottants, ayant un profil de compensation inversé résolu en profondeur par rapport à ses domaines (3') de compensation voisins dans la structure (AS) active.

**3.** Composant à semiconducteur suivant la revendication 1 ou 2,
**caractérisé en ce que** la structure (RS) de bord représente une région (RB) de bord du composant à semiconducteur.

**4.** Composant à semiconducteur suivant l'une des revendications 1 à 3,
**caractérisé en ce que** la structure (RS) de bord représente une région (ZB) intermédiaire entre un élément (HE) principal et un élément (NE) secondaire du composant à semiconducteur.

**5.** Composant à semiconducteur suivant l'une des revendications 1 à 4,
**caractérisé en ce que** la structure (RS) de bord comporte une structure en cellule, qui correspond sensiblement à une structure en cellule de la structure (AS) active du composant à semiconducteur.

**6.** Composant à semiconducteur suivant la revendication 5,
**caractérisé en ce que** la structure en cellule constitue sensiblement un polygone.

**7.** Composant à semiconducteur suivant l'une des revendications 1 à 6,
**caractérisé en ce que** la pluralité de zones (4) de compensation de bord est constituée de manière annulaire.

**8.** Composant à semiconducteur suivant la revendication 7,
**caractérisé en ce que** la pluralité de zones (4) de compensation de bord constitue des polygones annulaires.

**9.** Composant à semiconducteur suivant l'une des revendications 1 à 8,
**caractérisé en ce que** la pluralité de zones (4) de compensation de bord a des degrés (K) de compensation différents.

**10.** Composant à semiconducteur suivant l'une des revendications 1 à 9,
**caractérisé en ce que** la pluralité de zones (4) de compensation de bord n'a un degré (K) de compensation inversé que dans certaines régions d'une direction z.

**11.** Composant à semiconducteur suivant l'une des revendications 1 à 10,
**caractérisé en ce qu'**une variation de la dimension de la pluralité de zones (4) de compensation de bord s'effectue uniformément et/ou différemment dans la direction x, dans la direction y et dans la direction z.

**12.** Composant à semiconducteur suivant l'une des revendications 1 à 11,
**caractérisé en ce que** la pluralité de zones (4) de compensation de bord est constituée avec une trame ou sans une trame dans la direction x, dans la direction y et dans la direction z.

**13.** Composant à semiconducteur suivant l'une des revendications 1 à 12,
**caractérisé en ce qu'**un dopage global dans la région de la structure (RS) de bord est plus petit que dans la structure (AS) active.

**14.** Composant à semiconducteur suivant l'une des revendications 1 à 13, **caractérisé en ce qu'**une structure en sillon élimine une partie du dopage dans la structure (RS) de bord.

**15.** Procédé de fabrication d'un composant à semiconducteur suivant l'une des revendications 1 à 14, comprenant les stades, dans lesquels :

a) on forme une pluralité de couches ($E_1$ à $E_4$) semiconductrices pour la réalisation des premiers domaines (2) de compensation de bord ;
b) on forme une pluralité de masques (5) pour les couches ($E_1$ à $E_4$) semiconductrices respectives ; et
c) on forme la pluralité de zones (4) de compensation de bord au moyen de la pluralité de masques (5) dans les couches ($E_1$ à $E_4$) semiconductrices respectives pour la réalisation du deuxième domaine (3) de compensation de bord, la constitution des zones (4) de compensation de bord s'effectuant au moyen d'une implantation d'ions et d'une diffusion thermique venant ensuite, de manière à obtenir les degrés de compensation inversés résolus en profondeur.

**16.** Procédé suivant la revendication 15, dans lequel la constitution de la pluralité des couches ($E_1$ à $E_4$) semiconductrices représentent un dépôt épitaxial.

**17.** Procédé suivant la revendication 15 ou 16, dans lequel, en faisant varier une dose d'implantation, une ouverture dans le masque et/ou une durée de la diffusion thermique, on règle le degré (K) de compensation dans les zones (4) de compensation de bord.

FIG 1

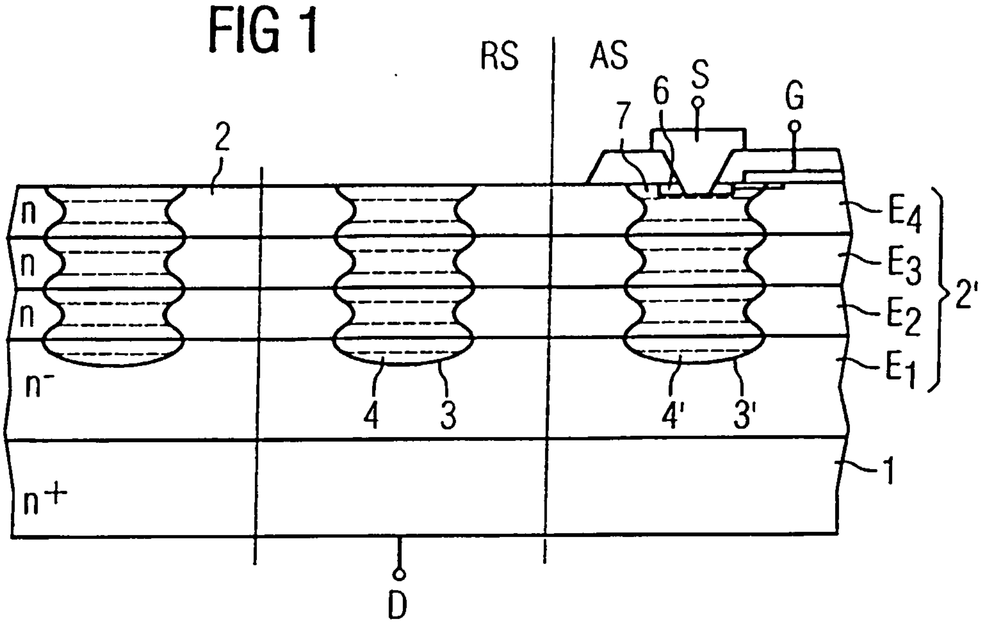


FIG 2

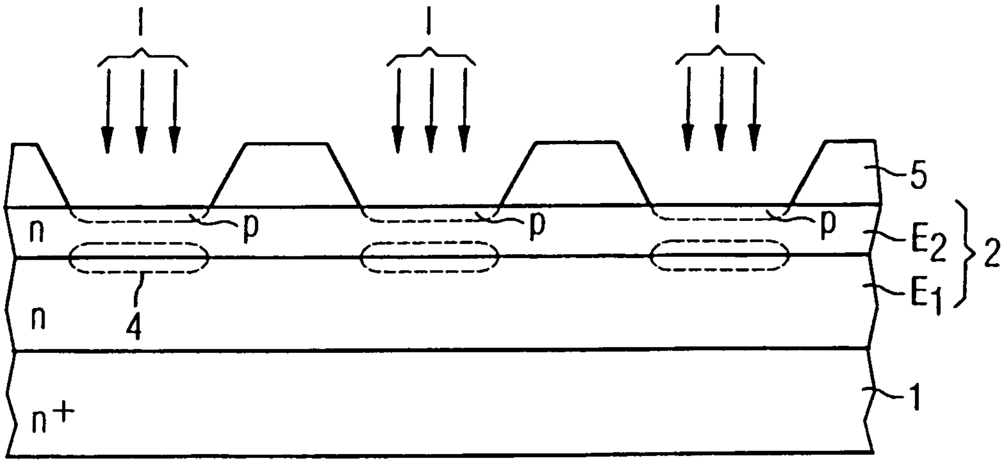

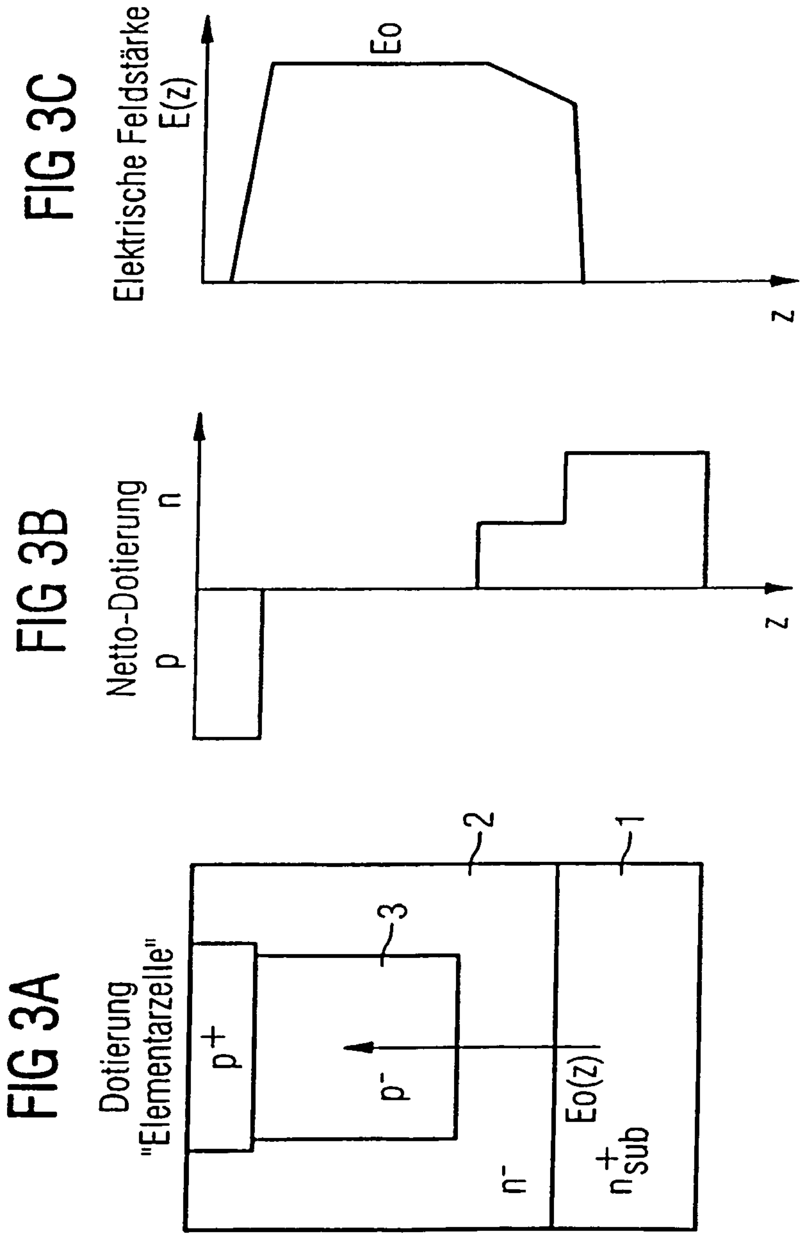
FIG 3A
Dotierung "Elementarzelle"
p+
p-
3
2
1
n-
Eo(z)
n+sub
FIG 3B
Netto-Dotierung
p
n
z
FIG 3C
Elektrische Feldstärke E(z)
Eo
z

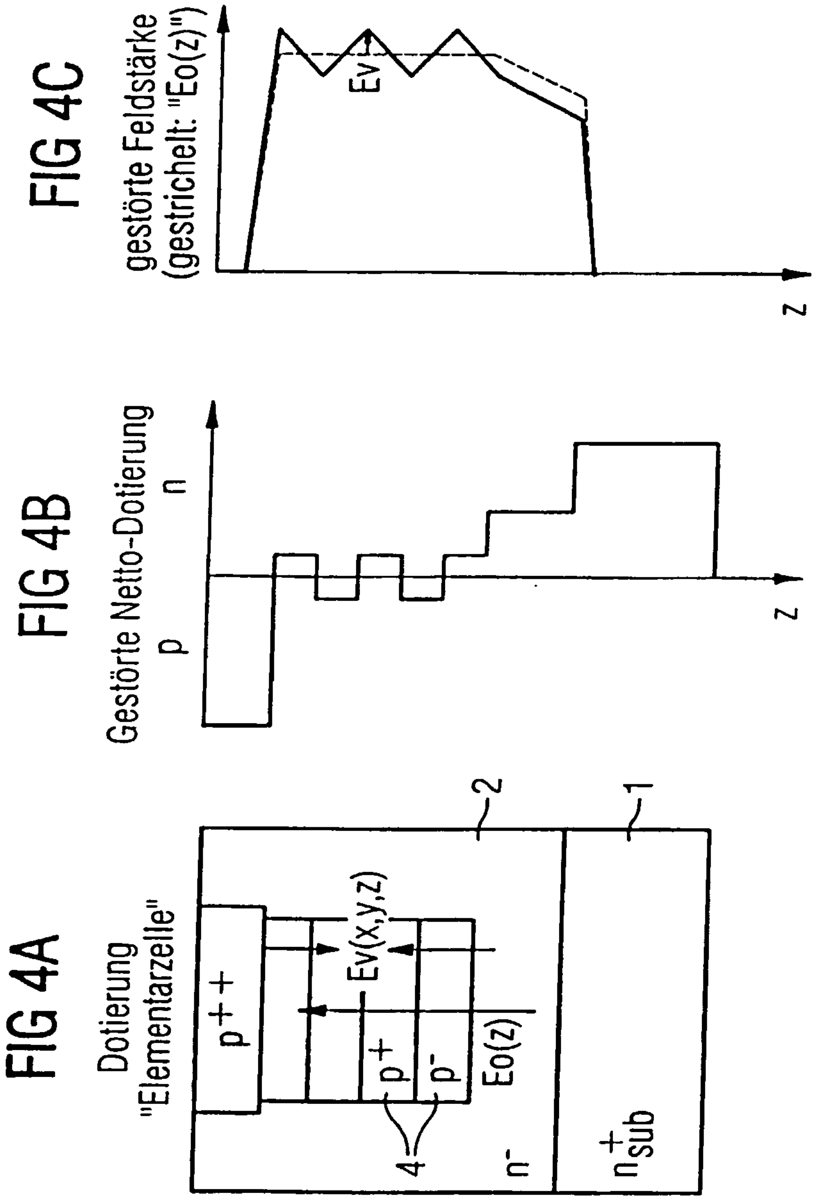


FIG 4A

FIG 4B

FIG 4C

FIG 5

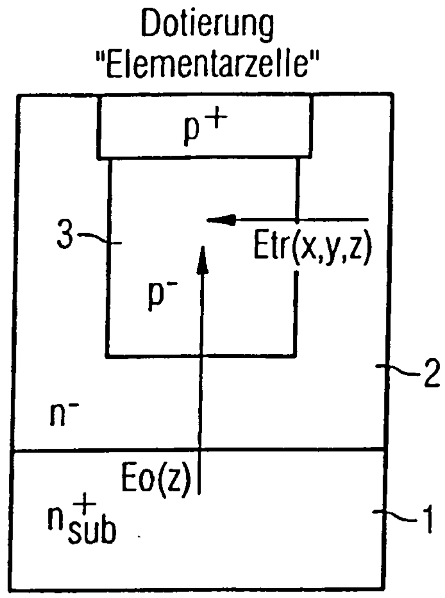
Dotierung
"Elementarzelle"
p+
3
Etr(x,y,z)
p-
2
n-
Eo(z)
n+sub
1

FIG 6

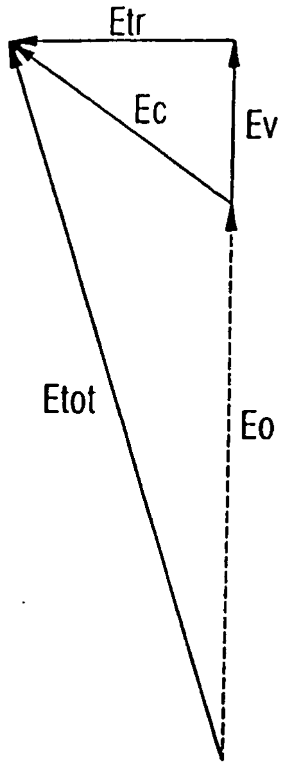
Etr
Ec
Ev
Etot
Eo

FIG 7A

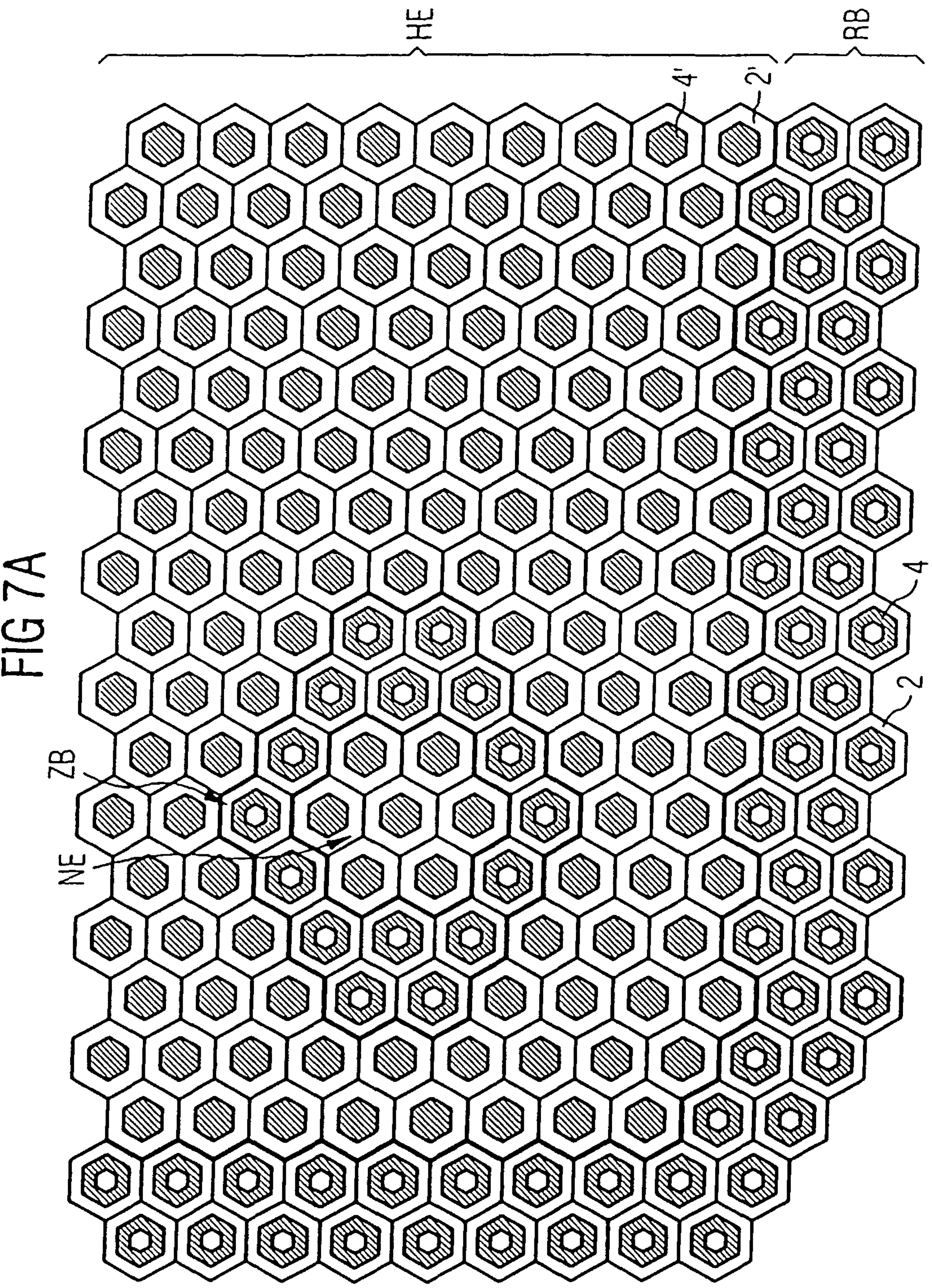

FIG 7B3

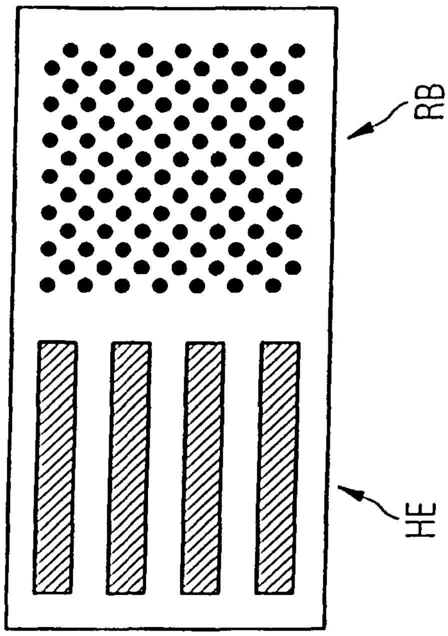


FIG 7B4

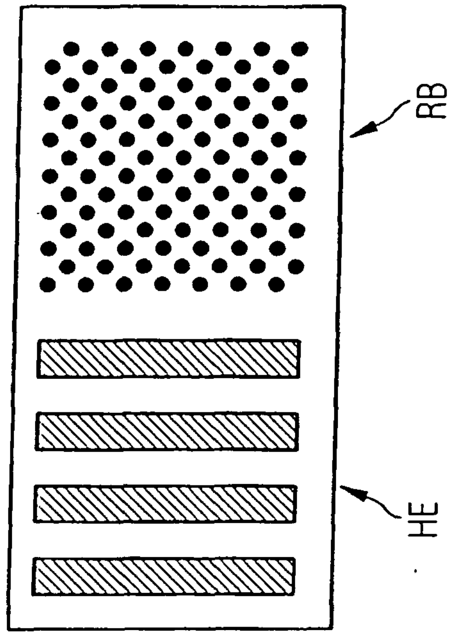


FIG 7B1

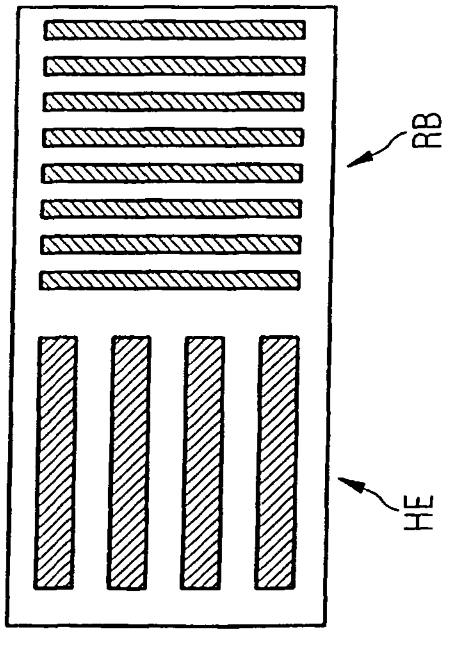


FIG 7B2

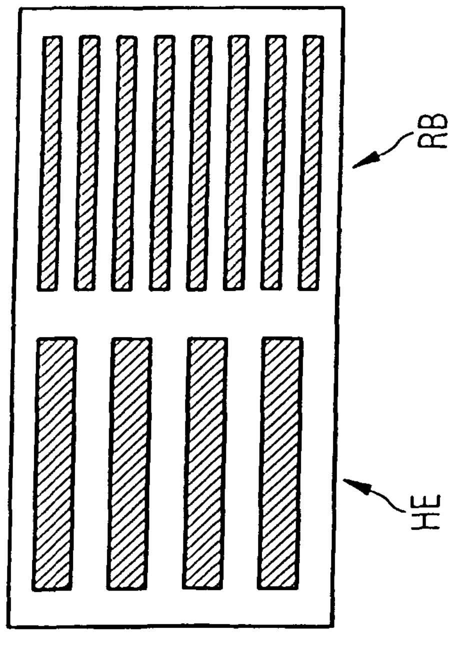

FIG 7B5

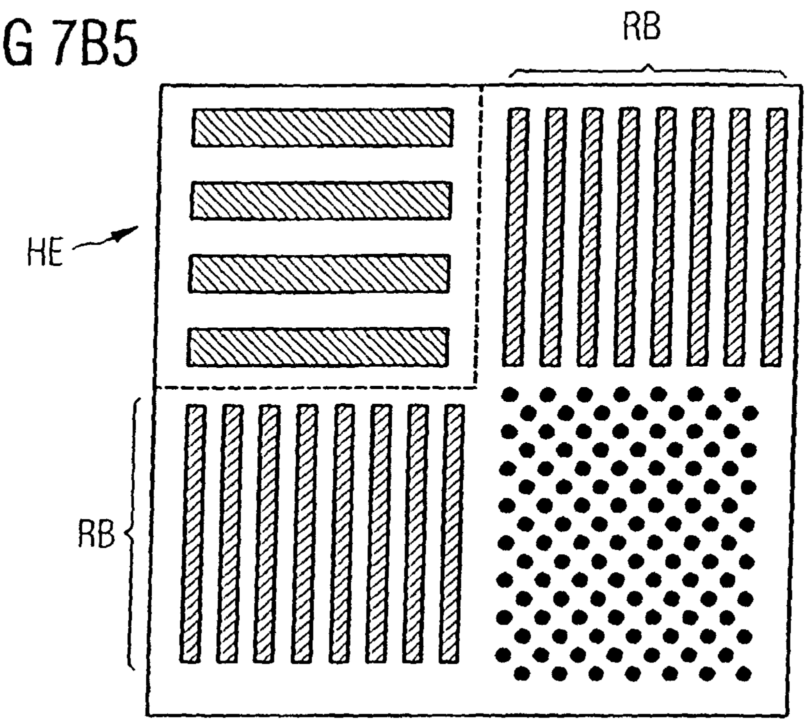


FIG 7B6

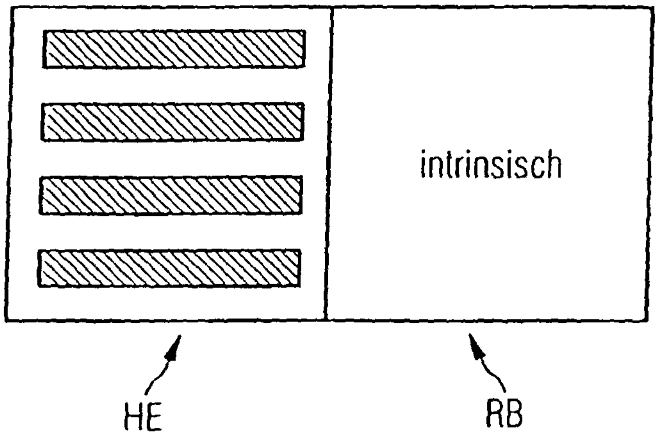


FIG 7B7

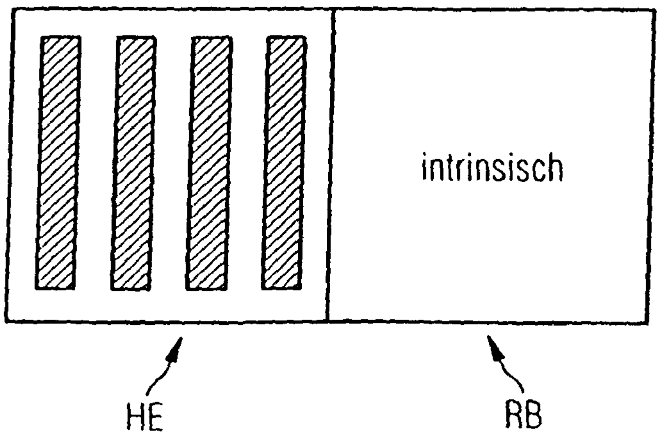

FIG 7B8

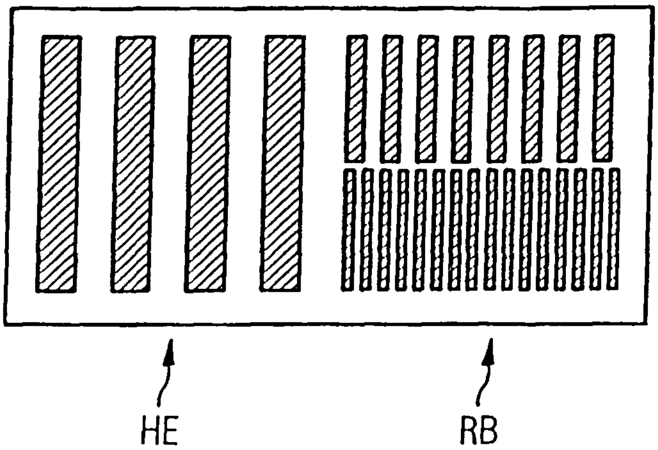


FIG 7B9

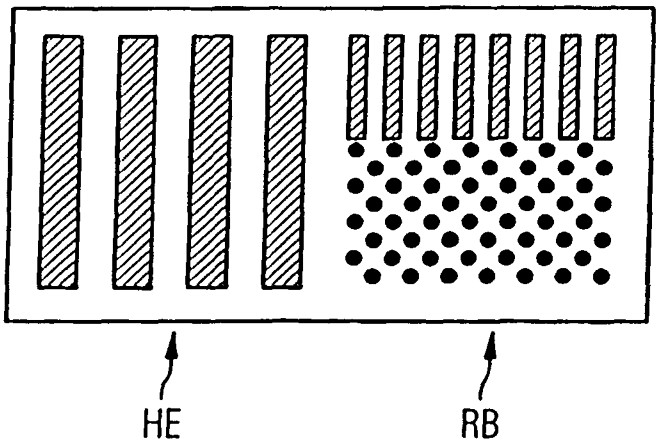

FIG 8

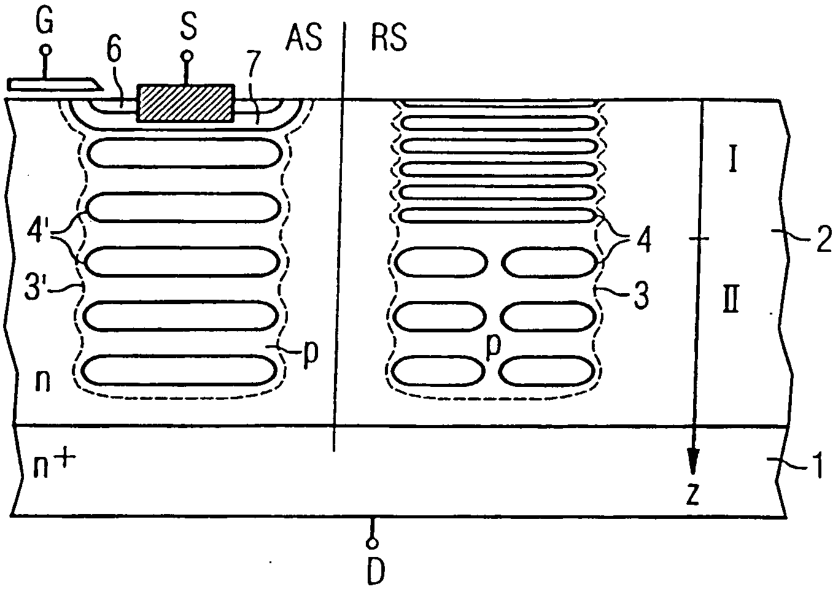
G
6
S
7
AS
RS
I
4'
4
2
3'
3
II
p
p
n
n+
1
z
D

FIG 9

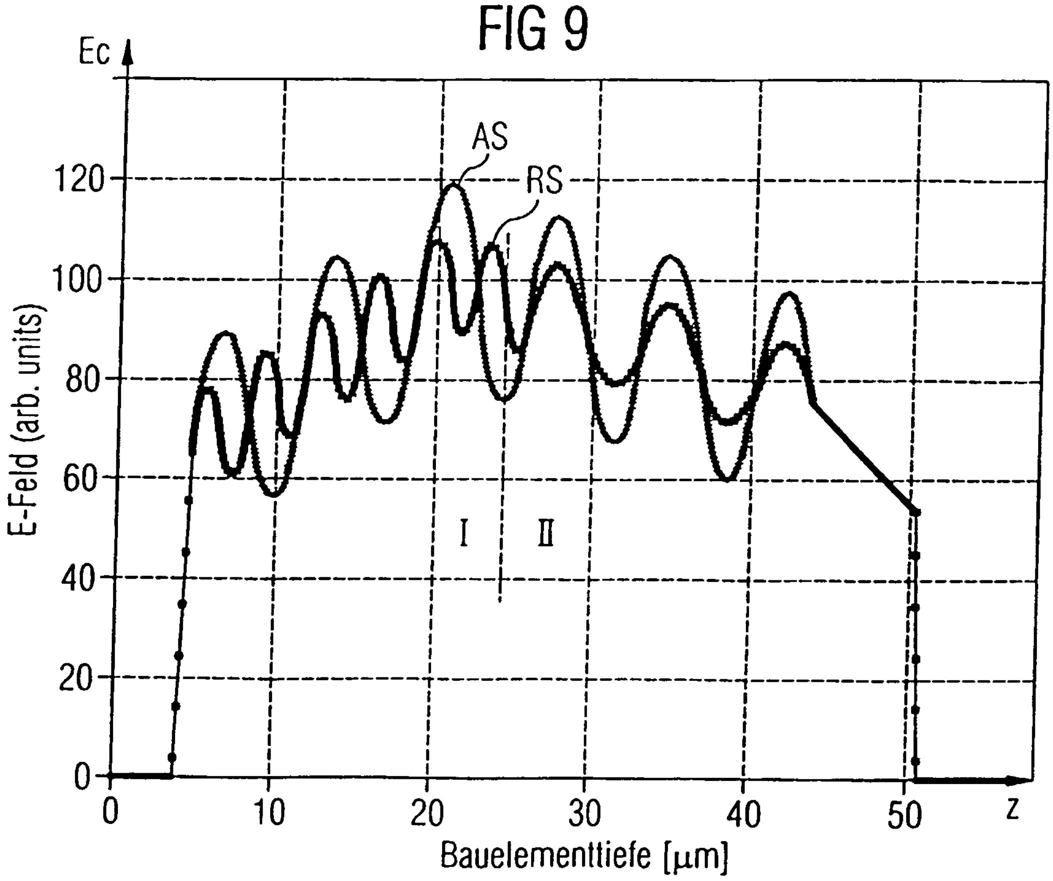
Ec
AS
RS
120
100
80
60
40
20
0
E-Feld (arb. units)
I
II
0
10
20
30
40
50
z
Bauelementtiefe [μm]

FIG 10

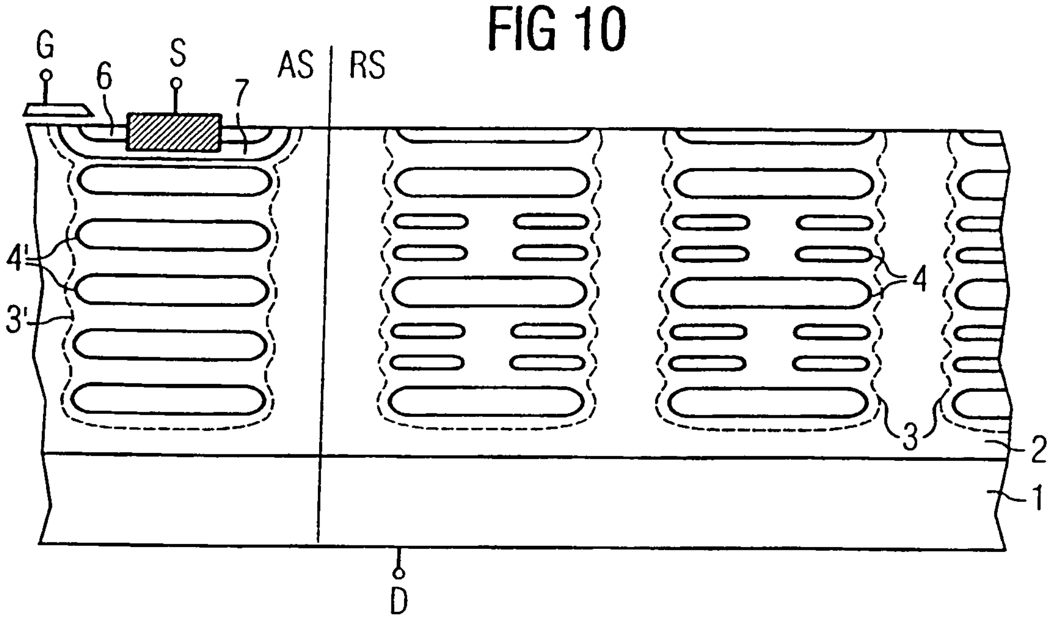


FIG 11

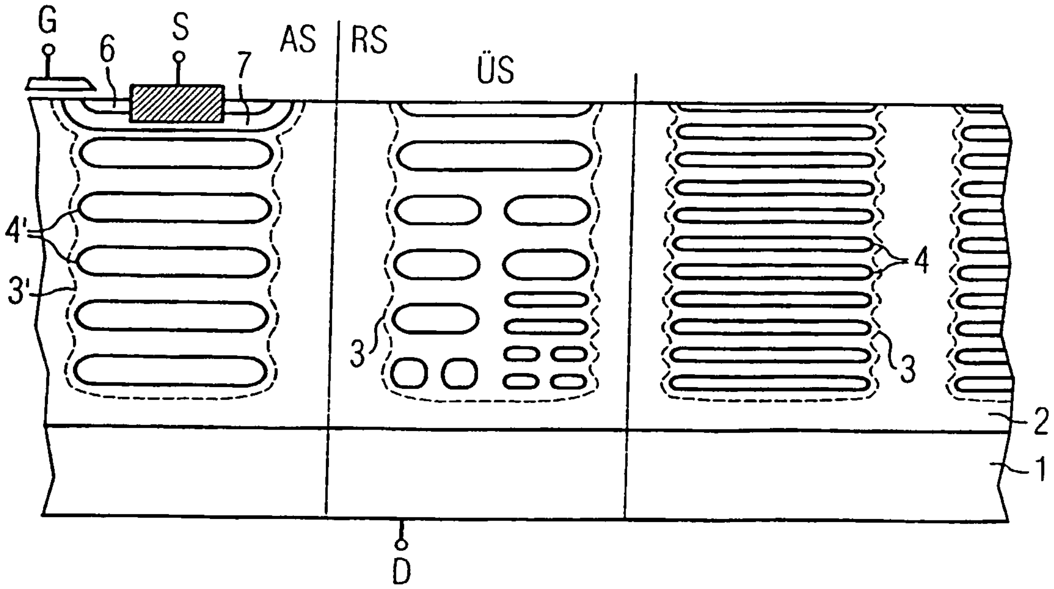

FIG 12

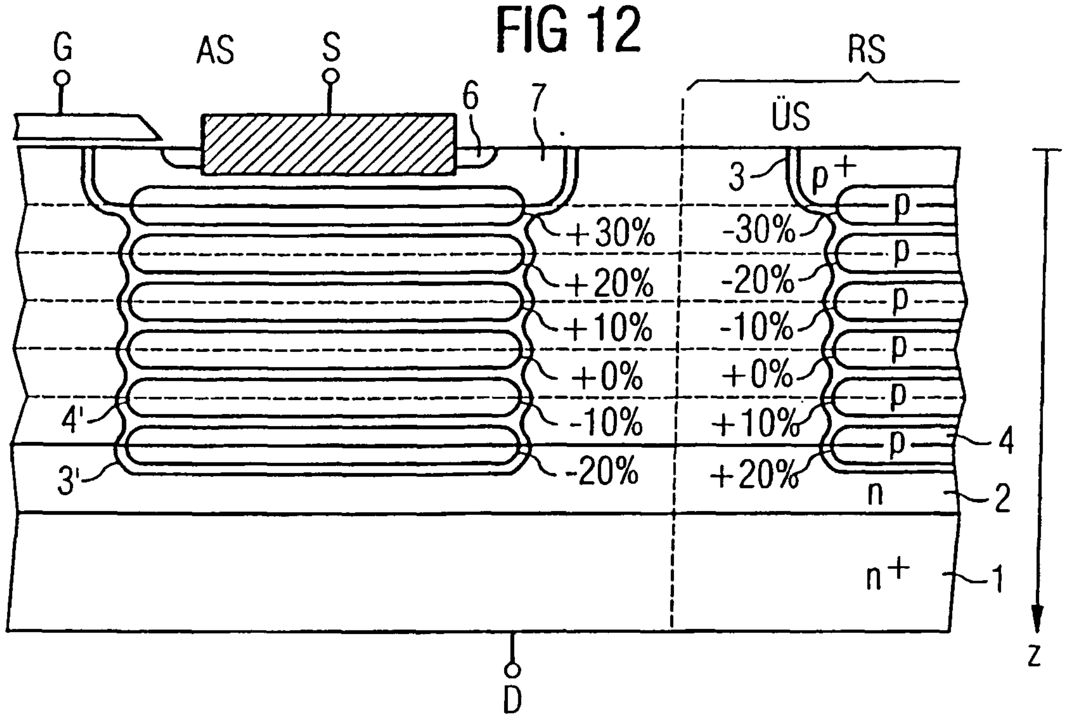
G
AS
S
6
7
RS
ÜS
3
p+
p
+30%
-30%
+20%
-20%
+10%
-10%
+0%
+0%
4'
-10%
+10%
4
3'
-20%
+20%
n
2
n+
1
z
D

FIG 13

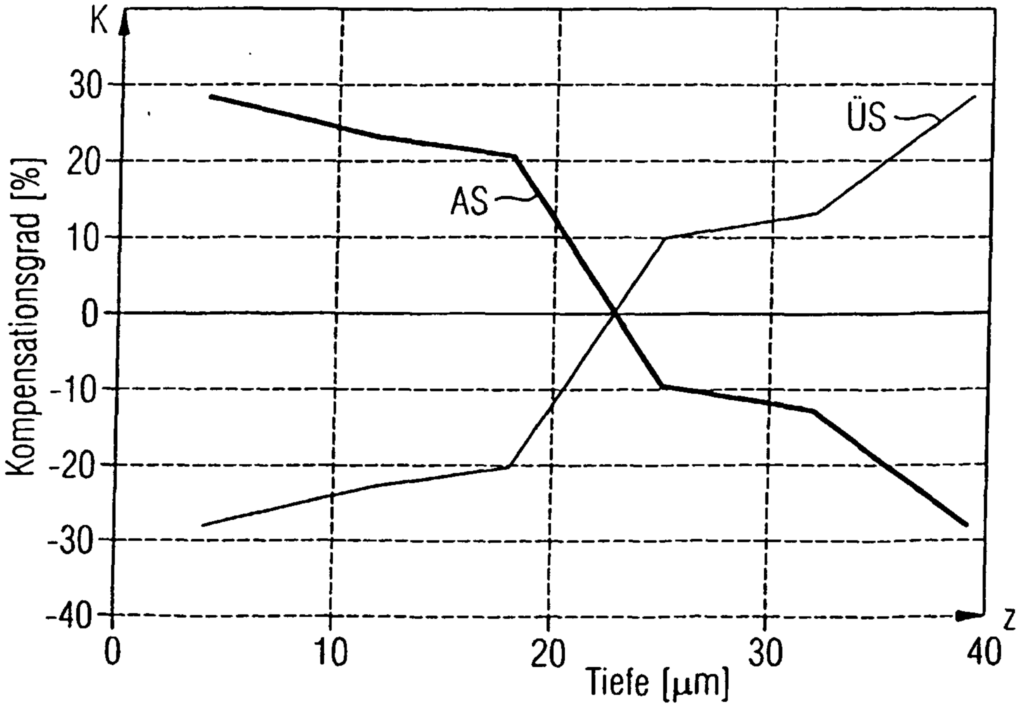
K
30
20
10
0
-10
-20
-30
-40
Kompensationsgrad [%]
ÜS
AS
0
10
20
30
40
z
Tiefe [µm]

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4754310 A
- US 5216275 A
- US 4750028 A
- WO 0014807 A
- DE 19954352 A1
- DE 19840032


### In der Beschreibung aufgeführte Nicht-Patentliteratur


- **Stengl et al.** Variation of Lateral Doping - A New Concept to Avoid High Voltage Breakdown of Planar Junctions. *International Electron Devices Meeting,* 01. Dezember 1985, 154-157